# EUROPEAN PATENT APPLICATION

(11) **EP 4 429 415 A1**
(43) Date of publication of application: **11.09.2024**
(21) Application number: 22890452.0
(22) Date of filing: 04.11.2022
(51) Int. Cl.: H05K 1/18, H05K 1/11, H05K 3/10, H05K 3/46, H01L 23/12

(54) **CIRCUIT BOARD**

(30) Priority: 05.11.2021 KR 20210151753
(71) Applicant: LG INNOTEK CO., LTD., Seoul 07796 (KR)
(72) Inventor: JUNG, Ji Chul, Seoul 07796 (KR); SHIN, Jong Bae, Seoul 07796 (KR); LEE, Soo Min, Seoul 07796 (KR); JEONG, Jae Hun, Seoul 07796 (KR)
(74) Representative: M. Zardi & Co S.A.
(86) International application number: PCT/KR2022/017264
(87) International publication number: WO 2023/080721

(57) **Abstract**

A circuit board according to an embodiment includes a first insulating layer; a second insulating layer disposed on the first insulating layer and including a cavity; and a first protective layer disposed on the second insulating layer and including an open portion vertically overlapping the cavity, wherein the cavity has a first inclination whose width decreases toward the first insulating layer, the open portion includes a first region whose width changes with a second inclination different from the first inclination, and at least a portion of the first region of the open portion is equal to a width of a region adjacent to the first protective layer among an entire region of the cavity.

## Description

### [Technical Field]

The embodiment relates to a circuit board and a semiconductor package including the same.

### [Background Art]

Recently, efforts have been made to develop improved 5G (5th generation) communication systems or pre-5G communication systems to meet the demand for wireless data traffic.

The 5G communication system uses ultra-high frequency (mm-Wave) bands (sub 6 GHz, 28 GHz, 38 GHz or higher frequencies) to achieve high data transfer rates. This high frequency band is called mm-Wave due to the length of the wavelength.

In order to alleviate the path loss of radio waves in the ultra-high frequency band and increase the transmission distance of radio waves, integration technologies such as beamforming, massive MIMO, and array antenna are being developed in 5G communication systems.

Considering that these frequency bands can consist of hundreds of active antennas of wavelengths, antenna systems can be relatively large.

This means that a plurality of boards that make up an active antenna system, that is, an antenna board, an antenna feed board, a transceiver board, a and baseband board, must be integrated into one compact unit.

Accordingly, the circuit board applied to the conventional 5G communication system has a structure in which a plurality of boards as described above are integrated, and thus has a relatively thick thickness. Accordingly, in a prior art, an overall thickness of the circuit board was reduced by thinning a thickness of an insulating layer constituting the circuit board.

However, there are limitations in manufacturing a circuit board by reducing the thickness of the insulating layer, and furthermore, as the thickness of the insulating layer becomes thinner, there is a problem in that the circuit pattern is not stably protected.

Accordingly, recently, a drill bit have been used to form cavities in the circuit board for embedding devices, or auxiliary materials such as release films are used to seat devices, or sand blast is used to form cavities for embedding devices.

At this time, in order to form a cavity in a conventional circuit board, a stop layer was needed to form a cavity of the desired depth in the cavity processing area. However, when using the stop layer, a process of removing the stop layer must be performed after the cavity is formed, and the resulting process becomes complicated.

Additionally, the stop layer is made of metal, and thus, in the prior art, the stop layer was removed by performing an etching process after the cavity was formed. However, there is a problem in that during the etching process of the stop layer, the pad disposed in the cavity is also removed, resulting in deformation of the pad. In addition, the above problem also occurs when forming a cavity using a sandblasting process.

In addition, a process of manufacturing a conventional circuit board includes a first process of laminating a plurality of insulating layers, a second process of forming a cavity in the plurality of insulating layers, a third process of forming a protective layer on the plurality of insulating layers, and a fourth process of forming an open portion in the protective layer that vertically overlaps the cavity. At this time, the process of forming the cavity is performed before the process of forming the open portion. Accordingly, there is a process deviation in the process of forming an open portion in the protective layer, as a result, a width of the open portion of the protective layer is formed to be larger than the width of the cavity. And, if the width of the open portion of the protective layer is greater than the width of the cavity, there is a problem in that a dead region is formed corresponding to a region between the open portion and an inner wall of the cavity. And, the dead region increases an overall size of the circuit board. And, if a circuit pattern layer exists in a region that vertically overlaps the dead region, a reliability problem in which the circuit pattern layer is exposed through the cavity or the open portion may occur.

### [Disclosure]

### [Technical Problem]

The embodiment provides a circuit board with a new structure and a semiconductor package including the same.

In addition, the embodiment provides a circuit board capable of eliminating a dead region by minimizing a width difference between the cavity of the insulating layer and an open portion of a protective layer, and a semiconductor package including the same.

In addition, the embodiment provides a circuit board that can improve an adhesion between a molding layer formed in a cavity of an insulating layer and an open portion of a protective layer, and a semiconductor package including the same.

In addition, the embodiment provides a circuit board capable of forming a cavity without a stop layer and a semiconductor package including the same.

Additionally, the embodiment provides a semiconductor package that can improve adhesion to the molding layer by providing a surface roughness above a certain level to a bottom surface of the cavity.

Technical problems to be solved by the proposed embodiments are not limited to the above-mentioned technical problems, and other technical problems not mentioned may be clearly understood by those skilled in the art to which the embodiments proposed from the following descriptions belong.

### [Technical Solution]

A circuit board according to an embodiment includes a first insulating layer; a second insulating layer disposed on the first insulating layer and including a cavity; and a first protective layer disposed on the second insulating layer and including an open portion vertically overlapping the cavity, wherein the cavity has a first inclination whose width decreases toward the first insulating layer, the open portion includes a first region whose width changes with a second inclination different from the first inclination, and at least a portion of the first region of the open portion is equal to a width of a region adjacent to the first protective layer among an entire region of the cavity.

In addition, the second inclination of the first region with respect to an upper surface of the first insulating layer vertically overlapping the cavity has a range between 80 degrees and 100 degrees.

In addition, the first inclination of the cavity with respect to the upper surface of the first insulating layer vertically overlapping the cavity has a range between 91 degrees and 130 degrees.

In addition, the open portion includes a second region adjacent to an upper surface of the first protective layer and having a third inclination different from the first and second inclinations.

In addition, at least a portion of an inner wall of the second region of the open portion includes a curved surface.

In addition, the first region of the open portion includes a recess portion adjacent to an upper surface of the second insulating layer and recessed toward an inside of the first protective layer.

In addition, the second inclination is an inclination between one end of an inner wall of the open portion adjacent to an upper surface of the first protective layer and other end of the inner wall of the open portion adjacent to a lower surface of the first protective layer, and the first inclination with respect to the upper surface of the first insulating layer vertically overlapping the cavity is smaller than the second inclination with respect to an upper surface of the first insulating layer vertically overlapping the cavity.

In addition, the second inclination is greater than the first inclination and has a range from 95 degrees to 160 degrees.

In addition, the open portion has a planar shape including a plurality of convex portions that are convex toward an inside of the first protective layer.

In addition, the cavity includes a plurality of second convex portions convex toward an inside of the second insulating layer, and a size of the first convex portion is different from a size of the second convex portion.

In addition, the size of the first convex portion is greater than the size of the second convex portion.

In addition, the circuit board includes a first circuit pattern layer disposed on the first insulating layer, the first circuit pattern layer includes a first pad part disposed on a first upper surface of the first insulating layer vertically overlapping the cavity, a second pad part disposed on a second upper surface of the first insulating layer that does not vertically overlap the cavity, and a trace connecting the first and second pad parts.

In addition, the trace includes a first portion disposed on a first upper surface of the first insulating layer and including one end directly connected to the first pad part, and a second portion disposed on the second upper surface of the first insulating layer and having the other end connected to the second pad part.

In addition, the second insulating layer includes a portion corresponding to a bottom surface of the cavity that vertically overlaps the cavity, and the bottom surface of the cavity is located higher than an upper surface of the first insulating layer and lower than an upper surface of the first circuit pattern layer.

Additionally, the bottom surface of the cavity includes a concave portion concave with respect to the first insulating layer and a convex portion convex with respect to the first insulating layer.

Meanwhile, the package substrate according to the embodiment includes a first insulating layer; a first circuit pattern layer disposed on the first insulating layer; a second insulating layer disposed on the first insulating layer and including a cavity; a first protective layer disposed on the second insulating layer and including an open portion vertically overlapping the cavity; a connection part disposed on a first circuit pattern layer vertically overlapping the cavity among the first circuit pattern layers; and a chip disposed on the connection part, wherein the cavity has a first inclination whose width decreases toward the first insulating layer, the open portion includes a first region whose width changes with a second inclination different from the first inclination, and at least a portion of the first region of the open portion is equal to a width of a region adjacent to the first protective layer among an entire region of the cavity.

In addition, the package substrate includes a molding layer filling at least a portion of the cavity and the open portion.

In addition, the chip includes a first chip and a second chip that are spaced apart from each other in a width direction or arranged in a vertical direction on the first insulating layer.

### [Advantageous Effects]

The circuit board of the embodiment includes a first insulating layer, a second insulating layer disposed on the first insulating layer, and a first protective layer disposed on the second insulating layer. And, a cavity is formed in the second insulating layer, and an open portion is formed in the first protective layer and vertically overlaps the cavity.

At this time, in the embodiment, after forming an open portion in the first protective layer in a process of manufacturing a circuit board, a cavity is formed in the second insulating layer by using the first protective layer as a mask. Accordingly, the open portion of the first protective layer in the embodiment may include a region having a width equal to a width of the cavity. For example, at least a portion of the regions in a thickness direction of the open portion of the first protective layer of the embodiment may have a width equal to a width of at least a portion of the region in the thickness direction of the cavity. Accordingly, the embodiment can minimize a difference between the width of the open portion of the first protective layer and the width of the open portion of the cavity, and eliminate or minimize a dead region that occur due to the difference in width. Additionally, the embodiment may eliminate the dead region or minimize a size of the dead region. Accordingly, an overall size of the circuit board can be reduced, and through this, the circuit board can be slimmed.

In addition, the open portion of the first protective layer of the embodiment includes a region whose width changes while adjacent to the upper surface of the first protective layer. For example, the inner wall of the open portion of the first protective layer includes a portion having a curved surface and adjacent to the upper surface of the first protective layer. And, the embodiment allows the inner wall of the open portion of the first protective layer to include a portion having a curved surface, and accordingly, process characteristics can be improved by facilitating the placement of a chip in a process of mounting the chip in the cavity. Furthermore, the embodiment can improve the flowability of the molding layer in a process of filling the molding layer in the cavity, and further improve adhesion with the molding layer.

Additionally, the inner wall of the open portion of the first protective layer of the embodiment includes a recess portion recessed toward an inside of the first protective layer in a region adjacent to the cavity. At this time, the recess portion may be a dead region in which at least a portion of the upper surface of the second insulating layer is not covered by the first protective layer. At this time, the first protective layer of the embodiment includes a region that vertically overlaps the recess portion. Through this, the embodiment allows the recess portion not to function as a dead region, thereby reducing the size of the dead region compared to the comparative example, and further eliminating the dead region.

Additionally, the embodiment allows the recess portion to be filled with a molding layer that fills the cavity. Through this, the embodiment can increase a contact area between the first protective layer, the second insulating layer, and the molding layer, and thereby improve the adhesion of the molding layer.

Meanwhile, the second insulating layer includes a first region vertically overlapping the cavity and a second region other than the first region. In addition, the first region of the second insulating layer has a certain thickness. Accordingly, the cavity of the embodiment may have a non-penetrating structure in which the first region remains on the first insulating layer rather than penetrating the second insulating layer. Accordingly, the embodiment can remove a stop layer that is essential in a process of forming a cavity in the second insulating layer, and accordingly, a manufacturing process can be simplified by omitting a process of forming the stop layer and a process of removing it.

In addition, the circuit board of the embodiment includes a first circuit pattern layer. At this time, the first region of the second insulating layer constitutes a bottom surface of the cavity. Additionally, a thickness of the first region of the second insulating layer is set to satisfy a range of 20% to 95% of a thickness of the first circuit pattern layer. Accordingly, the embodiment can solve problems such as non-exposure of the first circuit pattern layer that occurs when the first region of the second insulating layer has a greater thickness than the first circuit pattern layer, and furthermore, it is possible to solve the reliability problem caused by the upper surface of the first insulating layer being exposed in the first region of the second insulating layer.

In addition, the first circuit pattern layer in the embodiment includes a first pattern portion disposed in a region vertically overlapping with the first region, and a second pattern portion disposed in a region that vertically overlaps the second region. At this time, the cavity of the embodiment is formed through a laser process without a stop layer, and thus traces can be placed in a region that vertically overlaps the first region. For example, the first circuit pattern layer of the embodiment includes a trace directly connecting the first pattern portion and the second pattern portion. Accordingly, the embodiment allows the placement of the trace and allows direct connection between the first pattern portion and the second pattern portion using the trace. Accordingly, the embodiment can reduce a signal transmission distance between the first pattern portion and the second pattern portion, and thereby minimize signal transmission loss. In addition, the trace in the embodiment includes a first portion disposed in the first region and a second portion disposed in the second region. At this time, a width of the first portion of the trace may change during a laser process of forming the cavity. For example, the width of the first portion of the trace may be smaller than the width of the second portion. Through this, the embodiment can refine the width of the trace in the first region and thus improve circuit integration.

In addition, the first region of the second insulating layer in the embodiment has an egg plate shape according to a laser process and may have a surface roughness above a certain level. Accordingly, the embodiment can improve the adhesion between the molding layer filling the cavity and the second insulating layer, and thus improve the physical reliability of the semiconductor package.

### [Description of Drawings]

FIG. 1A is a cross-sectional view of a circuit board of a first comparative example.
FIG. 1B is a top view of the circuit board of FIG. 1A.
FIG. 1C is a cross-sectional view of a circuit board of a second comparative example.
FIGS. 2A and 2B are views showing a circuit board according to a first embodiment.
FIG. 3A is an enlarged view of one of cavity regions of FIGS. 2A and 2B.
FIG. 3B is a top view of FIG. 3A.
FIG. 3C shows a micrograph of a product corresponding to FIG. 3A.
FIG. 4A is a first enlarged view of an open portion region of any one of FIGS. 2A and 2B.
FIG. 4B is a second enlarged view of an open portion region of any one of FIGS. 2A and 2B.
FIG. 4C is a third enlarged view of an open portion region of any one of FIGS. 2A and 2B.
FIG. 4D shows a micrograph of a product corresponding to FIG. 4C.
FIG. 5A is a diagram showing a circuit board according to a second embodiment.
FIG. 5B is an enlarged view of an open portion and cavity region of FIG. 5A.
FIG. 6 is a view showing a semiconductor package according to a first embodiment.
FIG. 7 is a view showing a semiconductor package substrate according to a second embodiment.
FIGS. 8 to 12 are views showing a method of manufacturing a circuit board shown in FIG. 2A in order of processes.

### [Modes of the Invention]

Hereinafter, embodiments of the present invention will be described in detail with reference to the accompanying drawings.

However, the spirit and scope of the embodiment is not limited to a part of the embodiments described, and may be implemented in various other forms, and within the spirit and scope of the present invention, one or more of the elements of the embodiments may be selectively combined and replaced.

In addition, unless expressly otherwise defined and described, the terms used in the embodiments of the present invention (including technical and scientific terms may be construed the same meaning as commonly understood by one of ordinary skill in the art to which this invention belongs, and the terms such as those defined in commonly used dictionaries may be interpreted as having a meaning that is consistent with their meaning in the context of the relevant art.

In addition, the terms used in the embodiments of the present invention are for describing the embodiments and are not intended to limit the present invention. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present invention, the terms such as first, second, A, B, (a), and (b) may be used. These terms are only used to distinguish the elements from other elements, and the terms are not limited to the essence, order, or order of the elements. In addition, when an element is described as being "connected", or "coupled" to another element, it may include not only when the element is directly "connected" to, or "coupled" to other elements, but also when the element is "connected", or "coupled" by another element between the element and other elements.

Further, when described as being formed or disposed "on (over)" or "under (below)" of each element, the "on (over)" or "under (below)" may include not only when two elements are directly connected to each other, but also when one or more other elements are formed or disposed between two elements. Furthermore, when expressed as "on (over)" or "under (below)", it may include not only the upper direction but also the lower direction based on one element.

Before describing embodiments of the present invention, a circuit board according to a comparative example will be described.

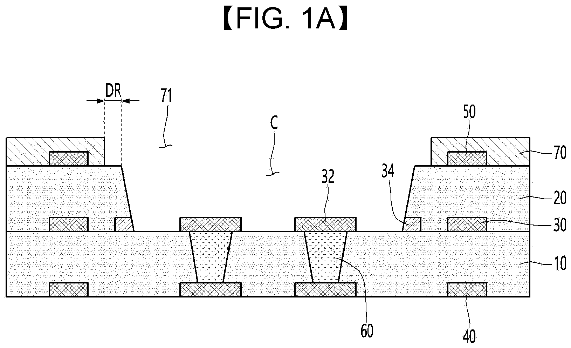

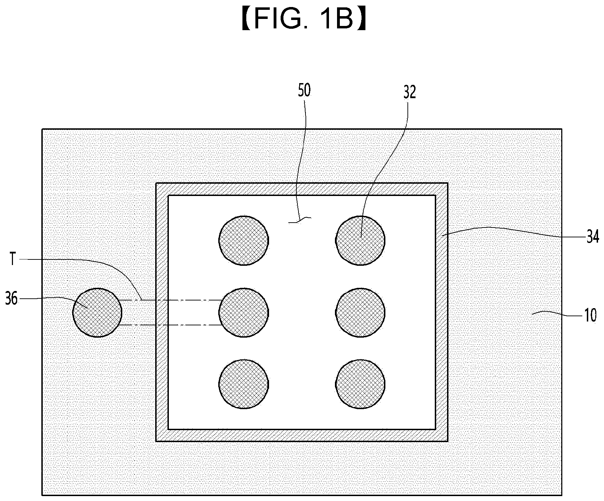

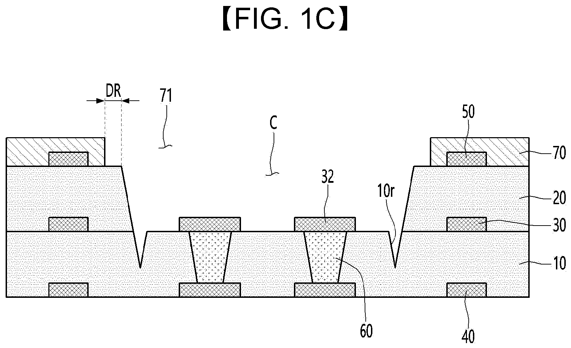

FIG. 1A is a cross-sectional view of the circuit board of the first comparative example, FIG. 1B is a top view of the circuit board of FIG. 1A, and FIG. 1C is a cross-sectional view of the circuit board of a second comparative example.

Referring to FIG. 1A, a circuit board according to a first comparative example includes a cavity (C).

The circuit board according to the first comparative example includes a cavity C having a structure that penetrates at least one insulating layer among a plurality of insulating layers.

Specifically, an insulating layer of the circuit board of the first comparative example includes a first insulating layer 10 and a second insulating layer 20 disposed on the first insulating layer 10.

And, the cavity C is formed penetrating the second insulating layer 20. Additionally, the circuit board includes a circuit pattern layer disposed on the surface of the insulating layer.

For example, the circuit board includes a first circuit pattern layer 30 disposed on an upper surface of the first insulating layer 10. Additionally, the circuit board includes a second circuit pattern layer 40 disposed on a lower surface of the first insulating layer 10. Additionally, the circuit board includes a third circuit pattern layer 50 disposed on the second insulating layer 20.

Additionally, the circuit board includes a through electrode 60 that penetrates the first insulating layer 10. The through electrode 60 electrically connects the first circuit pattern layer 30 disposed on the upper surface of the first insulating layer 10 and the second circuit pattern layer 40 disposed on the lower surface of the first insulating layer 10.

The upper surface of the first insulating layer 10 includes a first region R1 vertically overlapping the cavity (C) and a second region R2 excluding the first region. In this case, the first region of the first insulating layer 10 described below can be said to be an first upper surface of the first insulating layer 10, and the second region of the first insulating layer 10 can be said to be a second upper surface of the first insulating layer 10.

In addition, the first circuit pattern layer 30 may be disposed in the first region and the second region of the upper surface of the first insulating layer 10, respectively. At this time, in the first comparative example, a cavity C penetrating the second insulating layer 20 may be formed using a stop layer (not shown).

Accordingly, the first circuit pattern layer 30 includes a pad portion 32 disposed in a first region of the upper surface of the first insulating layer 10, and a stop pattern 34 disposed in a second region of the upper surface of the first insulating layer 10. The stop pattern 34 may be disposed at a boundary region between the first region and the second region on the upper surface of the first insulating layer 10. For example, the stop pattern 34 is disposed in the second region of the upper surface of the first insulating layer 10, and a side surface of the stop pattern may form a part of an inner wall of the cavity C. For example, the cavity C of the first comparative example may include a first inner wall including the second insulating layer 20 and a second inner wall including the stop pattern 34.

That is, as shown in FIG. 1B, in the first comparative example, the stop pattern 34 is disposed on the upper surface of the first insulating layer 10, surrounding the boundary region between the first region and the second region.

Accordingly, the first comparative example includes a process of forming a stop layer to form the cavity (C) and a process of forming the stop pattern 34 by removing the stop layer, and there is a problem in that the manufacturing process becomes complicated as a result.

Additionally, in the first comparative example, there is a problem that a portion of the pad portion 32 of the first circuit pattern layer 30 is also etched during the etching process for removing the stop layer, as a result, there is a problem in that the pad portion 32 is deformed. Additionally, in the first comparative example, if the pad portion 32 is deformed, a reliability problem may occur in which a connection part such as a solder ball is not stably seated on the pad portion 32.

In addition, in the first comparative example, the pad portion 32 disposed in the first region of the upper surface of the first insulating layer 10 has a problem in that it cannot be directly connected to other pattern portions 36 disposed in the second region of the upper surface of the first insulating layer 10.

For example, in the first comparative example, the stop pattern 34 is disposed in the boundary region corresponding to the cavity C. Accordingly, if there is a trace T connecting the pad portion 32 and the pattern portion 36, the trace T comes into electrical contact with the stop pattern 34, which may cause electrical reliability problems. For example, in the first comparison example, when there are at least two traces T, a problem may occur in which the traces T are electrically connected to each other by the stop pattern 34, and accordingly, a short circuit problem may occur as pad portions that should be electrically separated from each other are electrically connected to each other by the stop pattern 34.

Accordingly, in the first comparative example, the pad portion 32 and the pattern portion 36 are not directly connected to each other through traces, but are connected through the through electrode 60. Therefore, the first comparative example does not have a structure in which the pad portion 32 and the pattern portion 36 are directly connected to each other on the upper surface of the first insulating layer 10, and there is a problem that the length of the signal transmission line between them becomes longer, and as the length of the signal transmission line becomes longer, there is a problem that signal transmission loss increases due to vulnerability to noise.

Meanwhile, the circuit board in the first comparative example includes a protective layer 70 disposed on the second insulating layer 20. The protective layer 70 includes an open portion 71 that vertically overlaps the cavity C. The open portion 71 of the protective layer 70 vertically overlaps the cavity C. At this time, the width of the open portion 71 of the protective layer 70 is larger than the width of the cavity C.

This is because the time at which the open portion 71 of the protective layer 70 is formed is later than the time at which the cavity C is formed.

Specifically, in the first comparative example, after forming the cavity C in the second insulating layer 20, a protective layer 70 is formed on the second insulating layer 20, and an open portion 71 is formed on the protective layer 70. At this time, if the width of the open portion 71 is smaller than the width of the cavity C, there is a problem in which a chip (not shown) is not properly mounted in the cavity (C). Accordingly, the first comparative example must consider process deviations in the process of forming the open portion 71, and accordingly, the open portion 71 is formed to have a larger width than the cavity C. Accordingly, in the first comparative example, a dead region DR exists corresponding to a horizontal region between a sidewall of the open portion 71 and a sidewall of the cavity C. Additionally, the dead region DR has the problem of increasing an overall size of the circuit board.

In addition, as shown in FIG. 1C, in the second comparative example, the widths of the stop layer and the cavity 'C' are made the same, so that the stop pattern 34 is not remain on the circuit board. However, it is not easy to actually form the cavity C to correspond to the width of the stop layer due to process errors in the laser process. Accordingly, if the width of the stop layer is larger than the width of the cavity (C), there is a problem that a part of the stop pattern 34 as shown in FIG. 1A remains. Additionally, in the second comparative example, when the width of the stop layer is smaller than the width of the cavity (C), the cavity (C) is formed even in a region where the stop layer is not disposed, and accordingly, there is a problem in that a recess portion 10r is formed on the upper surface of the first insulating layer 10. In addition, the recess portion 10r has a problem of causing damage to the second circuit pattern layer 40 disposed on the lower surface of the first insulating layer 10, as a result, electrical reliability or physical reliability problems may occur. Additionally, the circuit board of the second comparative example also includes a protective layer 70 including the same open portion 71 as that of the first comparative example. Additionally, the circuit board of the second comparative example also includes a dead region DR.

At this time, in the first and second comparative examples, process conditions may be set so that the open portion 71 of the protective layer 70 and the cavity C have the same width. However, the open portion 71 is formed through exposure and development processes, and accordingly, there is a limit to forming the open portion 71 and the cavity C to have the same width due to process deviation. In addition, even if the process conditions are set so that the open portion 71 and the cavity C have the same width, process deviation occurs in a process of forming the open portion 71. Because of this, the width of the open portion 71 may be smaller than the width of the cavity C. Accordingly, additional reliability problems such as the chip not being placed in the correct position within the cavity C occur.

Accordingly, the embodiment provides a circuit board with a new structure that can solve the problems of the first and second comparative examples and a semiconductor package including the same.

For example, the embodiment allows a cavity C to be formed in a circuit board through a laser process without a stop layer. For example, the first circuit pattern layer of the embodiment is allowed to include traces that directly connect a first pad portion disposed in the first region of the first insulating layer and a second pad portion disposed in the second region. For example, the cavity C of the embodiment is allowed to have a non-penetrating structure rather than a structure penetrating the second insulating layer. For example, the bottom surface of the cavity C of the embodiment is allowed to be located higher than the lower surface of the second insulating layer.

Additionally, the embodiment allows the cavity and the open portion to have the same width, thereby eliminating dead regions.

This will be explained in more detail below.

### -Electronic device-

Before describing the embodiment, a semiconductor package having a structure in which a chip is mounted on a circuit board of an embodiment may be included in an electronic device.

In this case, the electronic device includes a main board (not shown). The main board may be physically and/or electrically connected to various components. For example, the main board may be connected to the semiconductor package of the embodiment. For example, the circuit board of the embodiment may be provided as a package board. In addition, various semiconductor devices may be mounted on the package substrate. The semiconductor package may include at least one of memory chips such as volatile memory (e.g., DRAM), non-volatile memory (e.g., ROM), and flash memory, application processor chips such as a central processor (e.g., CPU), graphics processor (e.g., GPU), digital signal processor, cryptographic processor, microprocessor, and microcontroller, and logic chips such as analogdigital converters and ASICs (application-specific ICs).

Additionally, the embodiment provides a semiconductor package in which two or more chips of different types are mounted on one substrate while reducing the thickness of the semiconductor package connected to the main board of the electronic device.

In this case, the electronic device may be a smart phone, a personal digital assistant, a digital video camera, a digital still camera, a vehicle, a high-performance server, a network system, computer, monitor, tablet, laptop, netbook, television, video game, smart watch, automotive, or the like. However, the embodiment is not limited thereto, and may be any other electronic device that processes data in addition to these.

Hereinafter, a circuit board according to an embodiment and a semiconductor package including the same will be described.

### -Circuit board-

Hereinafter, embodiments of the present invention will be described in detail with reference to the accompanying drawings.

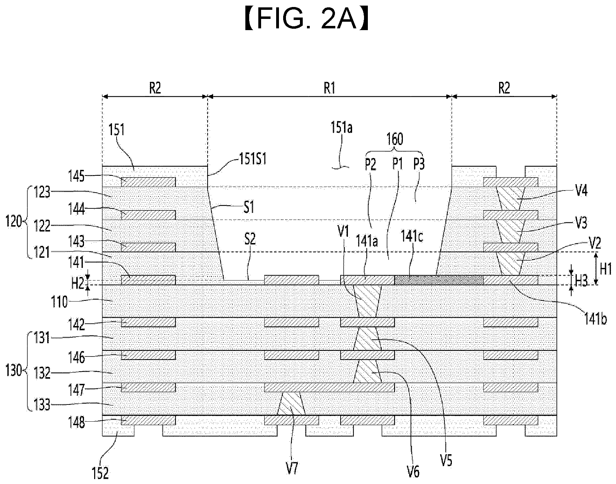

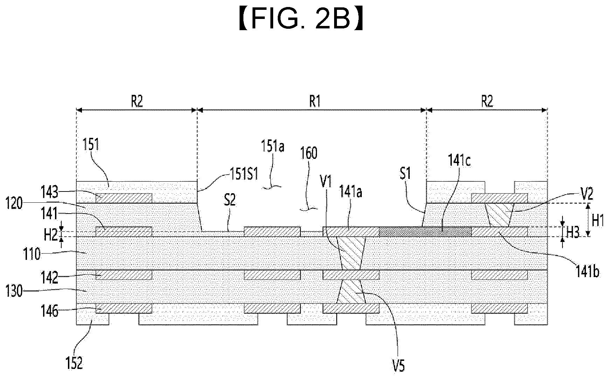

FIGS. 2A and 2B are views showing a circuit board according to a first embodiment.

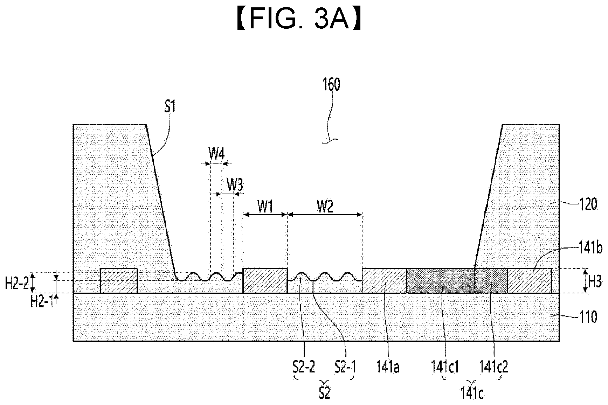

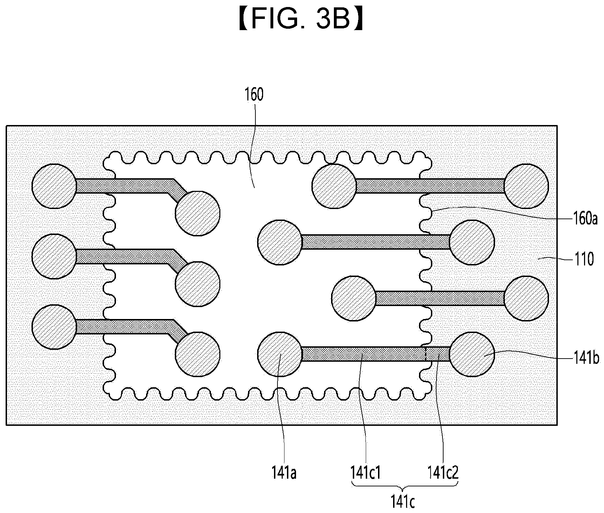

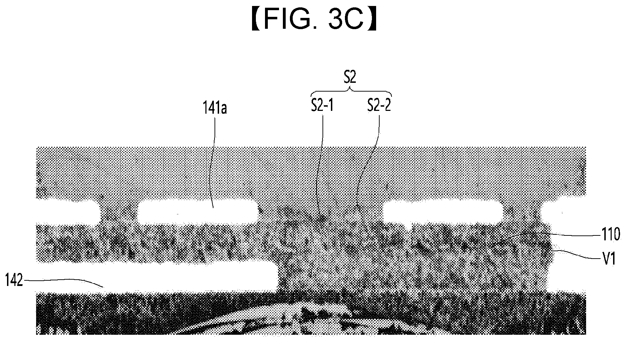

In addition, FIG. 3A is an enlarged view of one of cavity regions of FIGS. 2A and 2B, FIG. 3B is a top view of FIG. 3A, and FIG. 3C shows a micrograph of a product corresponding to FIG. 3A.

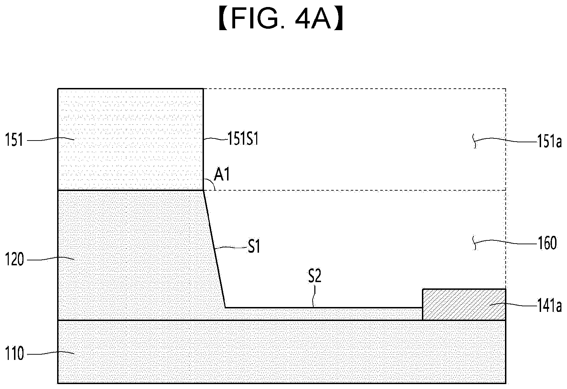

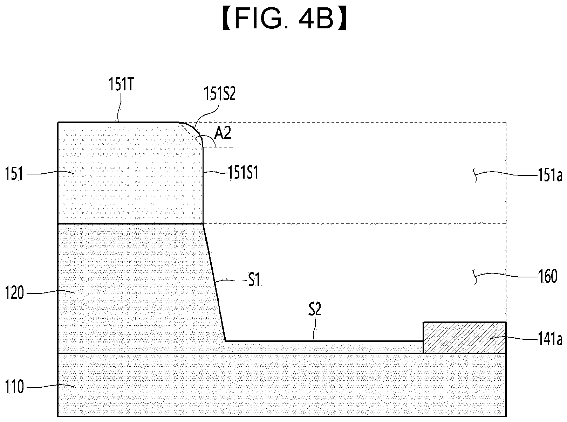

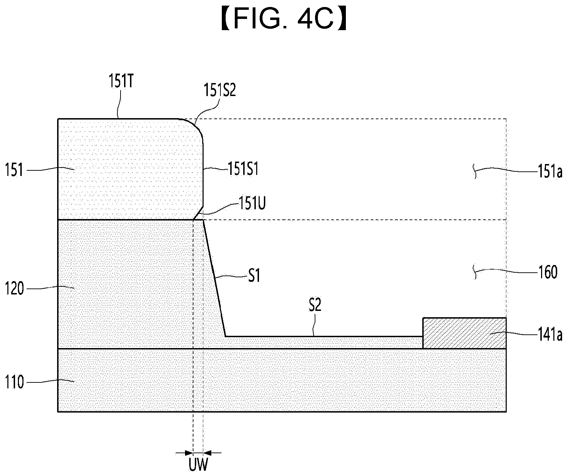

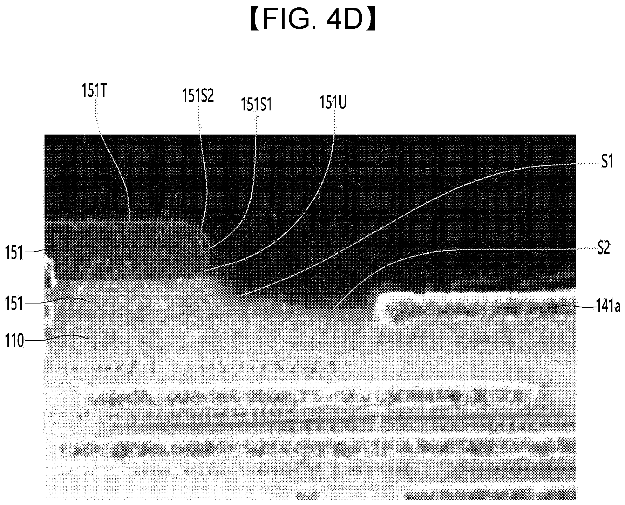

In addition, FIG. 4A is a first enlarged view of an open portion region of any one of FIGS. 2A and 2B, FIG. 4B is a second enlarged view of an open portion region of any one of FIGS. 2A and 2B, FIG. 4C is a third enlarged view of an open portion region of any one of FIGS. 2A and 2B, and FIG. 4D shows a micrograph of a product corresponding to FIG. 4C.

Hereinafter, an overall structure of the circuit board of the embodiment will be described with reference to FIGS. 2A and 2B, a structure of a cavity of the circuit board of the embodiment will be described with reference to FIGS. 3A to 3C, and a structure of an open portion of a first protective layer of the embodiment will be described with reference to FIGS. 4A to 4D.

Referring to FIGS. 2A and 2B, the circuit board 100 includes a first insulating layer 110, a second insulating layer 120, a third insulating layer 130, circuit pattern layers 141, 143, 144, 145, 146, 147, and 148, through electrodes V1, V2, V3, V4, V5, V6, and V7, and protective layers 151 and 152.

The first insulating layer 110 may be an insulating layer disposed at an inside of the circuit board 100. A second insulating layer 120 is disposed on the first insulating layer 110. Additionally, a third insulating layer 130 is disposed below the first insulating layer 110.

In this case, although the first insulating layer 110 is illustrated as being disposed in a center layer in an entire stacked structure of the circuit board 100 in the drawing, the embodiment is not limited thereto. That is, the first insulating layer 110 may be disposed at a position biased toward an upper side in the entire stacked structure of the circuit board 100, or, alternatively, may be disposed at a position biased toward a lower side.

Here, referring to FIG. 2A, the second insulating layer 120 is disposed on the first insulating layer 110. In this case, the second insulating layer 120 has a structure of a plurality of layers. For example, the second insulating layer 120 may be included a second-first insulating layer 121 disposed on a upper surface of the first insulating layer 110, a second-second insulating layer 122 disposed on a upper surface of the second-first insulating layer 121, and a second-third insulating layer 123 disposed on a upper surface of the second-second insulating layer 122. In this case, although it is illustrated that the second insulating layer 120 has a three-layer structure in the drawings, the embodiment is not limited thereto. That is, the second insulating layer 120 may be composed of two or less layers, or may be composed with a structure of four or more layers.

In addition, referring to FIG. 2A, the third insulating layer 130 is disposed under the first insulating layer 110. In this case, the third insulating layer 130 has a structure of a plurality of layers. For example, the third insulating layer 130 may include a third-first insulating layer 131 disposed under a lower surface of the first insulating layer 110, a third-second insulating layer 132 disposed under a lower surface of the third-first insulating layer 131, and a third-third insulating layer 133 disposed under a lower surface of the third-second insulating layer 132. In this case, although it is illustrated that the third insulating layer 130 has a three-layer structure in the drawings, the embodiment is not limited thereto. That is, the second insulating layer 130 may be composed with two or less layers, or may be composed with a structure of four or more layers.

In addition, although the circuit board 100 is illustrated as having a seven-layer structure based on the insulating layer in the drawings, the embodiment is not limited thereto. For example, the circuit board 100 may have a number of layers of 6 or less based on the insulating layer, or may have a number of layers of 8 or more.

Meanwhile, in FIG. 2A, the second insulating layer 120 and the third insulating layer 130 have been described as having a structure of a plurality of layers, but are not limited thereto. For example, the second insulating layer 120 and the third insulating layer 130 may be composed of a single layer.

That is, as shown in FIG. 2B, one layer of the second insulating layer 120 and one layer of the third insulating layer 130 may be respectively disposed above and below the first insulating layer 110.

Accordingly, in FIG. 2A, a cavity (to be described later) is formed in the second insulating layer 120 composed of a plurality of layers, and thus the cavity may have a structure of a plurality of layers.

In addition, in FIG. 2B, a cavity may be formed in the second insulating layer 120 composed of a single layer.

That is, a difference between the first embodiment in FIG. 2A and the second embodiment in FIG. 2B is whether the second insulating layer is composed of a plurality of layers or a single layer. In addition, the difference between the first embodiment in FIG. 1A and the second embodiment in FIG. 1B is whether the cavity formed in the second insulating layer is formed in a plurality of insulating layers or a single insulating layer.

In other words, the second insulating layer 120 in the embodiment may be composed of a plurality of layers, or may be composed of a single layer. In addition, a cavity may be formed in the plurality of layers or the single layer of the second insulating layer 120.

The first insulating layer 110, the second insulating layer 120, and the third insulating layer 130 are substrates on which an electric circuit capable of changing wiring is formed, and it may include a circuit board and an insulating substrate made of an insulating material capable of forming circuit patterns on the surface thereof.

For example, the first insulating layer 110 may be rigid or flexible. For example, the first insulating layer 110 may include glass or plastic. In detail, the first insulating layer 110 may include chemically strengthened/semitempered glass such as soda lime glass or aluminosilicate glass, or reinforced or soft plastics such as polyimide (PI), polyethylene terephthalate (PET), propylene glycol (PPG), and polycarbonate (PC), or sapphire.

In addition, the first insulating layer 110 may include an optical isotropic film. For example, the first insulating layer 110 may include a cyclic olefin copolymer (COC), a cyclic olefin polymer (COP), an optical isotropic polycarbonate (polycarbonate, PC) or photoisotropic polymethyl methacrylate (PMMA).

In addition, the first insulating layer 110 may be bent while having a partially curved surface. That is, the first insulating layer 110may be partially flat and partially curved while having a curved surface. In detail, the first insulating layer 110 may be curved while having a curved surface, or bent or curved while having a surface with random curvature.

In addition, the first insulating layer 110 may be a flexible substrate having a flexible property. In addition, the first insulating layer 110 may be a curved or bent substrate.

Preferably, the first insulating layer 110 may include prepreg. The prepreg may be formed by impregnating a fiber layer in the form of a fabric sheet, such as a glass fabric woven with glass yarn, with an epoxy resin, and then performing thermocompression. However, the embodiment is not limited to this, and the prepreg constituting the first insulating layer 110 may include a fiber layer in the form of a fabric sheet woven with carbon fiber yarn.

The first insulating layer 110 may include a resin and a reinforcing fiber disposed in the resin. The resin may be an epoxy resin, but is not limited thereto. The resin is not particularly limited to the epoxy resin, and for example, one or more epoxy groups may be included in the molecule, or alternatively, two or more epoxy groups may be included, or alternatively, four or more epoxy groups may be included. In addition, the resin of the first insulating layer 110 may include a naphthalene group, for example, may be an aromatic amine type, but is not limited thereto. For example, the resin may be include a bisphenol A type epoxy resin, a bisphenol F type epoxy resin, a bisphenol S type epoxy resin, a phenol novolac type epoxy resin, an alkylphenol novolac type epoxy resin, a biphenyl type epoxy resin, an aralkyl type epoxy resin, dicyclopentadiene type epoxy resin, naphthalene type epoxy resin, naphthol type epoxy resin, epoxy resin of condensate of phenol and aromatic aldehyde having phenolic hydroxyl group, biphenyl aralkyl type epoxy resin, fluorene type epoxy resin resins, xanthene-type epoxy resins, triglycidyl isocyanurate, rubber-modified epoxy resins, phosphorous-based epoxy resins, and the like, and naphthalene-based epoxy resins, bisphenol A-type epoxy resins, and phenol novolac epoxy resins, cresol novolak epoxy resins, rubber-modified epoxy resins, and phosphorous-based epoxy resins. In addition, the reinforcing fiber may include glass fiber, carbon fiber, aramid fiber (e.g., aramid-based organic material), nylon, silica-based inorganic material or titania-based inorganic material. The reinforcing fibers may be arranged in the resin to cross each other in a planar direction.

Meanwhile, the embodiment may use as the glass fiber, carbon fiber, aramid fiber (e.g., aramid-based organic material), nylon, silica-based inorganic material or titania-based inorganic material.

Additionally, the second insulating layer 120 and the third insulating layer 130 may include the same insulating material as the first insulating layer 110, or may include a different insulating material.

For example, the second insulating layer 120 and the third insulating layer 130 may include the same prepreg as the first insulating layer 110.

Preferably, the second insulating layer 120 and the third insulating layer 130 of the embodiment may be made of RCC (Resin Coated Copper).

That is, the plurality of layers constituting the second insulating layer 120 and the third insulating layer 130 of the first embodiment may each be composed of RCC. Additionally, the second insulating layer 120 and the third insulating layer 130 of the second embodiment may each be composed of RCC.

Accordingly, the second insulating layer 120 and the third insulating layer 130 may have a thickness of 5 µm to 20 µm. For example, when the second insulating layer 120 has a structure of a plurality of layers, each of the plurality of layers may have a thickness of 5 µm to 20 µm. In addition, when the second insulating layer 120 has a single layer, the thickness of the second insulating layer 120 of the single layer may be 5 µm to 20 µm.

That is, the insulating layer constituting the circuit board in the comparative example was composed of a prepreg containing glass fibers. In this case, it is difficult to reduce the thickness of the glass fiber based on the prepreg of the circuit board in the comparative example. This is because, when the thickness of the prepreg decreases, the glass fiber included in the prepreg may be electrically connected to a circuit pattern disposed on a surface of the prepreg, and thus a crack risk is induced. Accordingly, in the case of reducing the thickness of the prepreg of the circuit board in the comparative example, dielectric breakdown and damage to the circuit pattern may occur. Accordingly, the circuit board in the comparative example had a limitation in reducing the overall thickness due to the thickness of the glass fibers constituting the PPG.

Moreover, since the circuit board in the comparative example is comprised with the insulating layer only of prepreg containing glass fiber, it has a high dielectric constant. However, in the case of a dielectric having a high dielectric constant, there is a problem that it is difficult to use for high frequency. That is, in the circuit board of the comparative example, since the dielectric constant of the glass fiber is high, the dielectric constant is broken in the high frequency band.

Accordingly, in the embodiment, an insulating layer is formed by using an RCC having a low dielectric constant, thereby reducing the thickness of the circuit board and providing a highly reliable circuit board in which signal loss is minimized even in a high frequency band.

Meanwhile, as the second insulating layer 120 in the embodiment is made of RCC, the thickness of the circuit board can be remarkably reduced compared to the comparative example made of the prepreg. Accordingly, in the embodiment, the thickness of the circuit board can be reduced by at least 5 µm compared to the comparative example by using the RCC made of the low-dielectric constant material.

However, even when using an RCC having a low dielectric constant of 2.7, which is 10% improved from the level of 3.0, which is the dielectric constant of PPG, the decrease in thickness is only 10% compared to the comparative example. Therefore, the embodiment allows it possible to provide an optimal circuit board by forming a cavity through laser processing in a part where a chip such as an electronic device is mounted.

In this case, the first insulating layer 110 expresses the electrical wiring connecting the circuit components based on the circuit design as a wiring diagram, and may reproduce an electrical conductor on insulators. In addition, at least one of the first insulating layer 110, the second insulating layer 120, and the third insulating layer 130 is equipped with an electric component, it is possible to form a wiring connecting them in a circuit, and it can mechanically fix parts other than the electrical connection function of the parts.

Circuit pattern layers may be disposed on the surfaces of the first insulating layer 110, the second insulating layer 120, and the third insulating layer 130.

For example, a first circuit pattern layer 141 may be disposed on the upper surface of the first insulating layer 110. For example, the first circuit pattern layer 141 may include a plurality of circuit pattern portions disposed on the upper surface of the first insulating layer 110 at a predetermined distance from each other.

A second circuit pattern layer 142 may be disposed on the lower surface of the first insulating layer 110. A plurality of second circuit pattern layers 142 may be disposed on the lower surface of the first insulating layer 110 while being spaced apart from each other at a predetermined distance. At this time, the second circuit pattern layer 142 is shown as being formed to protrude below the lower surface of the first insulating layer 110, but is not limited thereto. For example, according to the circuit board manufacturing method of the embodiment, the second circuit pattern layer 142 may have a structure embedded in the first insulating layer 110 (for example, a structure protruding above the upper surface of the third insulating layer 130).

Additionally, circuit pattern layers may also be disposed on the surface of the second insulating layer 120. For example, the third circuit pattern layer 143 may be disposed on the upper surface of the second-first insulating layer 121. Additionally, a fourth circuit pattern layer 144 may be disposed on the upper surface of the second-second insulating layer 122. Additionally, a fifth circuit pattern layer 145 may be disposed on the upper surface of the second-third insulating layer 123.

Additionally, as shown in FIG. 2B, when the second insulating layer 120 is a single layer, a circuit pattern layer 143 may be disposed on the upper surface of the second insulating layer 120 of single layer.

Additionally, circuit patterns may be disposed on the surface of the third insulating layer 130. For example, when the third insulating layer 130 is composed of a single layer, the circuit pattern layer 146 may be disposed on the lower surface of the single layer of the third insulating layer 130.

Additionally, when the third insulating layer 130 is composed of a plurality of layers, a sixth circuit pattern layer 146 may be disposed on a lower surface of a third-first insulating layer 131. Additionally, a seventh circuit pattern layer 147 may be disposed on a lower surface of a third-second insulating layer 132. Additionally, an eighth circuit pattern layer 148 may be disposed on a lower surface of a third-third insulating layer 133.

Meanwhile, the first to eighth circuit pattern layers 141, 142, 143, 144, 145, 146, 147, and 148 as described above are wirings that transmit electrical signals, and may be formed of a metal material having high electrical conductivity. To this end, the first to eighth circuit pattern layers 141, 142, 143, 144, 145, 146, 147, and 148 may be formed of at least one metal material selected from gold (Au), silver (Ag), platinum (Pt), titanium (Ti), tin (Sn), copper (Cu), and zinc (Zn). In addition, the first to eighth circuit pattern layers 141, 142, 143, 144, 145, 146, 147, and 148 may be formed of a paste or solder paste including at least one metal material selected from gold (Au), silver (Ag), platinum (Pt), titanium (Ti), tin (Sn), copper (Cu), and zinc (Zn) having excellent bonding strength. Preferably, the first to eighth circuit pattern layers 141, 142, 143, 144, 145, 146, 147, and 148 may be formed of copper (Cu), which has high electrical conductivity and is relatively inexpensive.

The first to eighth circuit pattern layers 141, 142, 143, 144, 145, 146, 147, and 148 may be formed by an additive process, a subtractive process, a modified semi additive process (MSAP) and a semi additive process (SAP) method, which is a typical circuit board manufacturing process, and a detailed description thereof will be omitted herein.

Meanwhile, the first circuit pattern layer 141 is disposed on the upper surface of the first insulating layer 110.

At this time, an upper surface of the first insulating layer 110 may include a plurality of regions.

For example, the upper surface of the first insulating layer 110 includes a first region R1 that vertically overlaps the cavity (C). Additionally, the upper surface of the first insulating layer 110 includes a second region R2 other than the first region R1 that does not vertically overlap the cavity (C). At this time, the first region R1 of the first insulating layer 110 described below can be said to be the first upper surface of the first insulating layer 110, and the second region R2 of the first insulating layer 110 can be said to be the second upper surface of the first insulating layer 110.

In addition, the first circuit pattern layer 141 may be disposed in the first region R1 and the second region R2 of the upper surface of the first insulating layer 110, respectively.

For example, the first circuit pattern layer 141 includes a first pad portion 141a disposed in the first region R1 of the upper surface of the first insulating layer 110. The first pad portion 141a may be a mounting pad. For example, at least a portion of the first pad portion 141a may be disposed within the cavity 160. Additionally, the first pad portion 141a may be a pad on which a chip (described later) disposed in the cavity 160 is mounted. For example, the first pad portion 141a may be a wire bonding pad connected to a chip through a wire. For example, the first pad portion 141a may be a flip chip bonding pad on which terminals of the chip are disposed. This will be explained in more detail below.

Meanwhile, each of the first to eighth circuit pattern layers 141, 142, 143, 144, 145, 146, 147, and 148 may include a pattern connected to a via for interlayer conduction, a pattern for signal transmission, and a pad connected to an electronic device and the like.

Through electrodes V1, V2, V3, V4, V5, V6, and V7 that electrically connect circuit patterns disposed on different layers to each other may be disposed in the first insulating layer 110, the second insulating layer 120, and the third insulating layer 130. The through electrodes V1, V2, V3, V4, V5, V6, and V7 may pass through at least one of the first insulating layer 110, the second insulating layer 120, and the third insulating layer 130.

In addition, both ends of the through electrodes V1, V2, V3, V4, V5, V6, and V7 are respectively connected to circuit patterns disposed on different insulating layers, and thus an electrical signal may be transmitted.

A first through electrode V1 may be disposed in the first insulating layer 110. The first through electrode V1 may be disposed to pass through upper and lower surfaces of the first insulating layer 110. The first through electrode V1 may electrically connects the first circuit pattern layer 141 disposed on the upper surface of the first insulating layer 110 and the second circuit pattern layer 142 disposed on the lower surface of the first insulating layer 110.

A through electrode may be disposed in the second insulating layer 120.

For example, a second through electrode V2 may be disposed in the second-first insulating layer 121. The second through electrodeV2 may be electrically connected the first circuit pattern layer 141 disposed on the upper surface of the first insulating layer 110 and the third circuit pattern layer 143 disposed on the upper surface of the second-first insulating layer 121.

In addition, a third through electrode V3 may be disposed in the second-second insulating layer 122. The third through electrode V3 may be electrically connected the fourth circuit pattern layer 144 disposed on the upper surface of the second-second insulating layer 122 and the third circuit pattern layer 143 disposed on the upper surface of the second-first insulating layer 121.

In addition, a fourth through electrode V4 may be disposed in the second-third insulating layer 123. The fourth through electrode V4 may be electrically connected the fifth circuit pattern layer 145 disposed on the upper surface of the second-third insulating layer 123 and the fourth circuit pattern layer 144 disposed on the upper surface of the second-second insulating layer 122.

In addition, when the second insulating layer 120 is formed of a single layer, only the second through electrode V2 may be disposed in the single layer of the second insulating layer 120.

A through electrode may be disposed in the third insulating layer 130.

For example, a fifth through electrode V5 may be disposed in the third-first insulating layer 131. The fifth through electrode V5 may be electrically connected the second circuit pattern layer 142 disposed on the lower surface of the first insulating layer 110 and the sixth circuit pattern layer 146 disposed on the lower surface of the third-first insulating layer 131.

In addition, a sixth through electrode V6 may be disposed in the third-second insulating layer 132. The sixth through electrode V6 may be electrically connected the seventh circuit pattern layer 147 disposed on the lower surface of the third-second insulating layer 132 and the sixth circuit pattern layer 146 disposed on the lower surface of the third-first insulating layer 131.

In addition, a seventh through electrode V7 may be disposed in the third-third insulating layer 133. The seventh through electrode V7 may be electrically connected the eighth circuit pattern layer 148 disposed on the lower surface of the third-third insulating layer 133 and the seventh circuit pattern layer 147 disposed on the lower surface of the third-second insulating layer 132.

In addition, when the third insulating layer 130 is formed of a single layer, only the third through electrode V3 may be disposed in the single layer of the second insulating layer 120.

Meanwhile, the through electrodes V1, V2, V3, V4, V5, V6, and V7 may pass through only one insulating layer among the first insulating layer 110, the second insulating layer 120, and the third insulating layer 130, or alternatively, may be disposed while passing through a plurality of insulating layers in common. Accordingly, the through electrodes V1, V2, V3, V4, V5, V6, and V7 may connect circuit pattern layers disposed on the surface of the insulating layer that are at least two or more apart from each other, rather than the neighboring insulating layers.

Meanwhile, the through electrodes V1, V2, V3, V4, V5, V6, and V7 may be formed by filling the inside of a through hole (not shown) passing through at least one insulating layer among the plurality of insulating layers with a conductive material.

The through hole may be formed by any one of machining methods, including mechanical, laser, and chemical processing. When the through hole is formed by mechanical processing, methods such as milling, drilling, and routing may be used, and when the through hole is formed by laser processing, a UV or CO₂ laser method may be used, and when the through hole is formed by chemical processing, drugs containing amino silane, ketones, etc. may be used, and the like, thereby at least one insulating layer among the plurality of insulating layers may be opened.

On the other hand, the processing by the laser is a cutting method that takes the desired shape to melt and evaporate a part of the material by concentrating optical energy on the surface, it can easily process complex formations by computer programs, and can process composite materials that are difficult to cut by other methods.

In addition, the processing by the laser can have a cutting diameter of at least 0.005 mm, and has a wide advantage in a range of possible thicknesses.

As the drill for the laser processing, it is preferable to use a YAG (Yttrium Aluminum Garnet) laser, a CO₂ laser, or an ultraviolet (UV) laser. The YAG laser is a laser that can process both the copper foil layer and the insulating layer, and the CO₂ laser is a laser that can process only the insulating layer.

When the through hole is formed, the through electrodes V1, V2, V3, V4, V5, V6, and V7 may be formed by filling the inside of the through hole with a conductive material. Metal materials forming the through electrodes V1, V2, V3, V4, V5, V6, and V7 may be any one material selected from Cu, Ag, Sn, Au, Ni, and Pd, and the metal material may be filled using any one or a combination of electroless plating, electrolytic plating, screen printing, sputtering, evaporation, ink jetting and dispensing.

Meanwhile, protective layers 151 and 152 may be disposed on the surface of an outermost insulating layer among the first insulating layer 110, the second insulating layer 120, and the third insulating layer 130. For example, the first protective layer 151 may be disposed on an upper surface of an uppermost insulating layer disposed at an uppermost of the plurality of insulating layers. For example, the first protective layer 151 may be disposed on the upper surface of the second-third insulating layer 123 disposed at an uppermost portion of the second insulating layer 120.

In addition, a second protective layer 152 may be disposed on a lower surface of a lowermost insulating layer disposed at a lowermost portion among the plurality of insulating layers. For example, the second protective layer 152 may be disposed on a lower surface of the third-third insulating layer 133 disposed at the lowermost portion of the third insulating layer 130.

In addition, when the second insulating layer 120 and the third insulating layer 130 are each composed of a single layer, the first protective layer 151 may be disposed on the upper surface of the second insulating layer 120, and the second protective layer 152 may be disposed on the lower surface of the third insulating layer 130.

The first protective layer 151 and the second protective layer 152 may each have an open portion. For example, the first protective layer 151 may include an open portion that vertically overlaps at least a portion of the upper surface of the fifth circuit pattern layer 145 disposed on the upper surface of the second-third insulating layer 123.

Additionally, the second protective layer 152 may include an opening that vertically overlaps at least a portion of the lower surface of the eighth circuit pattern layer 148 disposed on the lower surface of the third-third insulating layer 133.

Additionally, the first protective layer 151 includes an open portion 151a that vertically overlaps the cavity 160 formed in the second insulating layer 120. The open portion 151a of the first protective layer 151 vertically overlaps the cavity 160, thereby providing a space for the chip to be placed. At this time, a width of the open portion 151a of the first protective layer 151 may correspond to a width of the cavity 160 formed in the second insulating layer 120. For example, at least one region among the regions in the thickness direction of the open portion 151a may have a width equal to the width of at least one of the regions in the thickness direction of the cavity 160. Through this, the embodiment can eliminate a dead region that occurs when the width of the open portion 151a is larger than the width of the cavity 160, thereby reducing the size of the circuit board. This will be explained in more detail below.

The first protective layer 151 and the second protective layer 152 may include an insulating material. The first protective layer 151 and the second protective layer 152 may include various materials that can be cured by heating after being applied to protect the surface of the circuit patterns. The first protective layer 151 and the second protective layer 152 may be resist layers. For example, the first protective layer 151 and the second protective layer 152 may be a solder resist layer including an organic polymer material. For example, the first protective layer 151 and the second protective layer 152 may include an epoxy acrylate-based resin. In detail, the first protective layer 151 and the second protective layer 152 may include a resin, a curing agent, a photo initiator, a pigment, a solvent, a filler, an additive, an acryl-based monomer, and the like. However, the embodiment is not limited thereto, and the first protective layer 151 and the second protective layer 152 may be any one of a photo solder resist layer, a cover-lay, and a polymer material.

A thickness of the first protective layer 151 and the second protective layer 152 may be 1 µm to 20 µm. The thickness of the first protective layer 151 and the second protective layer 152 may be 1 µm to 15 µm. For example, the thickness of the first protective layer 151 and the second protective layer 152 may be 5 µm to 20 µm. When the thickness of the first protective layer 151 and the second protective layer 151 is greater than 20 µm, the thickness of the circuit board may increase. When the thickness of the first protective layer 151 and the second protective layer 152 is less than 1 µm, the circuit pattern layers included in the circuit board 100 are not stably protected, which may result in reduced electrical or physical reliability.

Hereinafter, the cavity 160 and the open portion 151a of the embodiment will be described in detail.

First, the cavity 160 formed in the second insulating layer 120 will be described below.

Meanwhile, a cavity 160 may be formed in the second insulating layer 120. In this case, the cavity 160 may be disposed in the second insulating layer 120 composed of a plurality of layers or a single layer. In this case, the cavity 160 may be provided to pass through at least one insulating layer among the second insulating layers 120 composed of the plurality of layers, and may be provided to non-pass through at least another insulating layer.

That is, a cavity in the comparative example is provided passing through the insulating layer. For example, the cavity in the comparative example has a structure that passes through the upper surface to the lower surface of the second insulating layer.

Unlike this, the cavity 160 of the embodiment may not have a structure that pass through the upper and lower surfaces of the second insulating layer 120, but may have a structure that does not penetrate the upper and lower surfaces of the second insulating layer 120. For example, a bottom surface of the cavity may be positioned higher than the lower surface of the second insulating layer.

That is, the cavity 160 of the first embodiment may be formed in the second insulating layer 120. For example, the cavity 160 of the first embodiment may be formed in the second-first insulating layer 121, the second-second insulating layer 122, and the second-third insulating layer 123. For example, the cavity 160 of the second embodiment may be formed in the second insulating layer 120 composed of one layer.

At this time, when the second insulating layer 120 has a plurality of layer structure, in the comparative example, the cavity is formed to have a structure penetrating from the upper surface to the lower surface of the second insulating layer. Accordingly, the bottom surface of the cavity in the comparative example may be the same plane as the lower surface of the second insulating layer 120 or the same plane as the upper surface of the first insulating layer 110.

In contrast, the cavity 160 formed in the circuit board of the embodiment may have a structure that does not passes through the second insulating layer 120. For example, the cavity 160 of the embodiment may be formed without passing through the second-first insulating layer 121, which is the remaining part of the second insulating layer while penetrating through the second-second insulating layer 122 and the second-second insulating layer 123, which are part of the second insulating layer. Accordingly, the bottom surface of the cavity 160 may be positioned higher than the lower surface of the second-first insulating layer 121.

Accordingly, the cavity 160 may include a first part P1 disposed in the second-first insulating layer 121, a second part P2 disposed in the second-second insulating layer 122, and a third part P3 disposed in the second-third insulating layer 123. Here, as the second insulating layer 122 in the embodiment has a three-layer structure, the cavity 160 is illustrated as being composed of the first to third parts P1, P2, and P3, but the embodiment is not limited thereto. For example, when the second insulating layer 120 has a twolayer structure, the cavity 160 may include only the first and second parts. For example, when the second insulating layer 120 has a five-layer structure, the cavity 160 may include first to fifth parts. However, a part closest to the first insulating layer 110 among the plurality of parts constituting the cavity 160 of the embodiment may have a groove shape corresponding to a non-penetrating structure.

The first part P1 may be provided in the second-first insulating layer 121. In this case, the first part P1 may be a groove provided in the second-first insulating layer 121 and not passing through a lower region of the cavity 160.

The second part P2 may be provided in the second-second insulating layer 122. The second part P2 may be a through hole that passes through the second-second insulating layer 122 and forms a central region of the cavity 160.

The third part P3 may be provided in the second-third insulating layer 123. The third part P3 may be a through hole that passes through the second-third insulating layer 123 and forms an upper region of the cavity 160.

That is, the cavity 160 may be formed of a combination of the first part P1, the second part P2, and the third part P3. In this case, a thickness (or depth) of the first part P1 may be smaller than the thickness of the second-first insulating layer 121. Accordingly, the cavity 160 may be formed without passing the second-first insulating layer 121.

Additionally, the second insulating layer 120 may be formed as a single layer. When the second insulating layer 120 has a single-layer structure, the cavity 160 may include only the first part P1.

The second insulating layer 120 may include a first region R1 vertically overlapping the cavity 160 and a second region R2 excluding the first region R1. The first region R1 of the second insulating layer 120 may refer to a region in which the cavity 160 is formed. At this time, the first region R1 of the second insulating layer 120 may be referred to as a first insulating portion of the second insulating layer 120, and the second region R2 may be referred to as a second insulating portion of the second insulating layer.

Meanwhile, when the second insulating layer 120 is composed of multiple layers, the first region R1 of the second insulating layer 120 may include a partial region of the second insulating layer disposed at a lowermost side among the plurality of second insulating layers, and the second region R2 of the second insulating layer 120 may be a region including all of the plurality of second insulating layers 120.

Additionally, a thickness H2 of the first region R1 of the second insulating layer 120 may be different from a thickness H1 of the second region of the second insulating layer 120.

In the first embodiment of FIG. 2A, the thickness H2 of the first region R1 of the second insulating layer 120 may refer to the thickness of the second-first insulating layer 120 among the second insulating layers composed of a plurality of layers. In the second embodiment of FIG. 2B, the thickness H2 of the first region R1 of the second insulating layer 120 may refer to a thickness of the second insulating layer 120 composed of a single layer.

Meanwhile, in the embodiment, the second insulating layer 120 may be composed of a plurality of layers, or alternatively, the second insulating layer 120 may be composed of a single layer, and in this case, the thickness H1 of the second insulating layer 120 in the first region R1 may be substantially the same.

The thickness H2 of the first region R1 of the second insulating layer 120 may be thinner than the thickness H3 of the first circuit pattern layer 141. For example, the upper surface S2 (e.g., the bottom surface of the cavity) of the first region R1 of the second insulating layer 120 may be curved. For example, the upper surface S2 of the first region R1 of the second insulating layer 120 may have a curved surface rather than a flat surface. And, the thickness H2 of the first region R1 of the second insulating layer 120 may mean an average thickness of the first region R1 of the second insulating layer 120. The thickness H2 of the first region R1 of the second insulating layer 120 may be smaller than the thickness H3 of the first circuit pattern layer 141. For example, the upper surface S2 of the first region R1 of the second insulating layer 120 may be located lower than the upper surface of the first circuit pattern layer 141.

Preferably, the thickness H2 of the first region R1 of the second insulating layer 120 may satisfy a range of 20% to 95% of the thickness H3 of the first circuit pattern layer 141. Preferably, the thickness H2 of the first region R1 of the second insulating layer 120 may satisfy a range of 25% to 90% of the thickness H3 of the first circuit pattern layer 141. Preferably, the thickness H2 of the first region R1 of the second insulating layer 120 may satisfy a range of 30% to 85% of the thickness H3 of the first circuit pattern layer 141.

If the thickness H2 of the first region R1 of the second insulating layer 120 is less than 20% of the thickness H3 of the first circuit pattern layer 141, the upper surface of the first insulating layer 110 may be damaged due to process deviation in the laser process for forming the cavity 160. In addition, when the thickness H2 of the first region R1 of the second insulating layer 121 is greater than 95% of the thickness H3 of the first circuit pattern layer 141, process deviation occurs in the laser process for forming the cavity 160, as a result, a problem may occur in which the upper surface S2 of the first region R1 of the second insulating layer 120 is located higher than the upper surface of the first circuit pattern layer 141. In this case, an upper surface of the first pad portion 141a of the first circuit pattern layer 141 disposed in the first region R1 of the first insulating layer 110 may be covered by the first region R1 of the second insulating layer 120, as a result, problems may occur in the chip mounting process.

In this case, in the comparative example, in order to form the cavity in the plurality of insulating layers as described above, the cavity forming process was performed in a state in which a protective layer or a stop layer was disposed on the first insulating layer. Accordingly, in the prior art, the cavity could be formed to a desired depth (a depth passing all of the second insulating layer). However, in the related art, after the cavity is formed, an etching process of removing the protective layer or the stop layer has to be performed. Accordingly, in the prior art, a portion of the pad portion disposed on the first insulating layer is also removed during the etching process of removing the protective layer or the stop layer, which may cause a problem in reliability of the pad portion. In this case, the thickness of the protective layer or stop layer required for sand blasting or laser processing is 3um to 10um, and accordingly, there is a problem in that an amount corresponding to the thickness of the protective layer or the stop layer among the total thickness of the pad is removed during the etching process.

Accordingly, in the embodiment, the cavity can be easily formed without forming the protective layer or the stop layer, thereby solving the reliability problem that occurs during the process of removing the protective layer or the stop layer.

In addition, the cavity 160 can be formed to have a structure that does not passes through the second insulating layer 120 by controlling the process conditions for forming the cavity.

In this case, the cavity 160 may be formed by a laser process. Here, in the absence of the protective layer or the stop layer, it is not easy to form a cavity to a desired depth through the laser process. In this case, in the embodiment, the process conditions of the laser are controlled based on the range between the minimum depth and the maximum depth that the cavity 160 should have, and through this, the cavity 160 can be formed to a desired depth. Here, the controlled process conditions may include a laser process speed and laser energy density. That is, by changing the process speed and intensity conditions while the laser process progress time is fixed, the depth of the cavity 160 can be controlled in um units. Accordingly, in the embodiment, the cavity 160 can be formed within a range between a minimum depth and a maximum depth that the cavity should have by adjusting the laser process speed and laser energy density. The maximum depth of the cavity 160 may be smaller than a vertical distance from the upper surface to the lower surface of the second insulating layer 120.

Specifically, the cavity 160 includes an inner wall and a bottom surface S2.

The inner wall S1 and the bottom surface S2 of the cavity 160 may have a predetermined surface roughness. In this case, in the embodiment, an additional process is not performed so that the inner wall S1 and the bottom surface S2 of the cavity 160 have a predetermined surface roughness, and the surface roughness may be formed during the laser process for forming the cavity 160.

In other words, the bottom surface S2 of the cavity 160 may mean the upper surface of the first region R1 of the second insulating layer 120. Additionally, the upper surface S2 of the first region R1 of the second insulating layer 120 or the bottom surface S2 of the cavity 160 may be curved.

For example, a surface roughness (Ra) of the bottom surface S2 of the cavity 160 in the embodiment may range from 0.5 µm to 3 µm. For example, a surface roughness of the bottom surface S2 of the cavity 160 in the embodiment may range from 0.7 µm to 2.8 µm. For example, the surface roughness (Ra) of the bottom surface S2 of the cavity 160 in the embodiment may range from 0.8 µm to 2.5 µm. This may be due to the laser process having the following shape in the embodiment. For example, when the surface roughness (Ra) of the bottom surface S2 of the cavity 160 in the embodiment is outside the range between 0.8 µm and 2.5 µm, it may be difficult to form the cavity 160 with the same shape as in the embodiment without a stop layer.

Meanwhile, in the embodiment, the cavity 160 is formed using a Gaussian beam. In this case, the outermost portion of the cavity 160 is processed using a center point of the Gaussian beam. That is, the center point of the Gaussian beam generates the laser with a highest energy density, and accordingly, an inclination angle of the inner wall of the cavity 160 at the outermost portion may be smaller than an inclination angle of the inner wall of the cavity of the comparative example.

For example, the inner wall S1 of the cavity 160 may have an inclination whose width decreases from the upper surface to the lower surface of the second insulating layer 120.

For example, the inclination of the inner wall S1 of the cavity 160 may mean an inclination angle with respect to the upper of the first region R1 of the first insulating layer 110.

At this time, the inclination of the inner wall S1 of the cavity 160 may range from 91 degrees to 130 degrees. For example, the inclination of the inner wall S1 of the cavity 160 may range from 93 degrees to 125 degrees. For example, the inclination of the inner wall S1 of the cavity 160 may range from 95 degrees to 120 degrees.

If the inclination of the inner wall S1 of the cavity 160 is less than 91 degrees, the cavity 160 may have an inverted trapezoidal shape whose width increases from the lower surface to the upper surface of the second insulating layer 120. In this case, the placement position of the chip may be distorted during the process of placing the chip in the cavity 160, as a result, problems may arise where the chip is mounted in a distorted state. In addition, if the inclination of the inner wall S1 of the cavity 160 is greater than 130 degrees, a space occupied by the cavity 160 may increase due to a difference between lower and upper widths of the cavity 160, as a result, a volume of the circuit board (e.g., width in a horizontal direction or thickness in a vertical direction) may increase, or circuit integration may decrease.

The bottom surface S2 of the cavity 160 or the upper surface S2 of the first region R1 of the second insulating layer 120 may have an egg plate shape. For example, the bottom surface S2 of the cavity 160 or the upper surface S2 of the first region R1 of the second insulating layer 120 may include a first portion S2-1 and a second portion S2-2.

For example, the bottom surface S2 of the cavity 160 or the first portion S2-1 of the upper surface S2 of the first region R1 of the second insulating layer 120 may be a concave portion concave toward the lower surface of the second insulating layer 120. Additionally, the bottom surface S2 of the cavity 160 or the second portion S2-2 of the upper surface S2 of the first region R1 of the second insulating layer 120 may be a convex portion.

The first portion S2-1 may be formed to correspond to a laser beam (e.g., Gaussian beam) having a certain width irradiated to the second insulating layer 120 in a process of forming the cavity 160 in the second insulating layer 120. For example, a width W3 of the first portion S2-1 may correspond to the width of the laser beam irradiated to the second insulating layer 120 in a process of forming the cavity 160.

Additionally, the second portion S2-2 may be a portion formed by movement of a laser beam moves during the process of forming the cavity 160 in the second insulating layer 120. For example, the laser process to form the cavity 160 may include a process of irradiating a first laser beam at a first position, and a process of irradiating a second laser beam at a second position spaced apart from the first position by a predetermined distance. Additionally, the second portion S2-2 may be formed to correspond to a separation width between the first and second positions. For example, a width W4 of the second portion S2-2 may correspond to the separation width between the first position and the second position. For example, the width W4 of the second portion S2-2 may correspond to a movement width of the laser beam during the forming process of the cavity 160.

At this time, the width W3 of the first portion S2-1 or the width W4 of the second portion S2-2 may be smaller than the width W1 of the first pad portion 141a of the first circuit pattern layer 141 or the spacing W2 between the first pad portions 141a.

For example, the width W3 of the first portion S2-1 or the width W4 of the second portion S2-2 may satisfy a range of 5% to 90% of the width W1 of the first pad portion 141a of the first circuit pattern layer 141 or the spacing W2 between the first pad portions 141a. For example, the width W3 of the first portion S2-1 or the width W4 of the second portion S2-2 may satisfy a range of 10% to 85% of the width W1 of the first pad portion 141a of the first circuit pattern layer 141 or the spacing W2 between the first pad portions 141a. For example, the width W3 of the first portion S2-1 or the width W4 of the second portion S2-2 may satisfy a range of 15% to 80% of the width W1 of the first pad portion 141a of the first circuit pattern layer 141 or the spacing W2 between the first pad portions 141a.

If the width W3 of the first portion S2-1 or the width W4 of the second portion S2-2 is smaller than 5% of the width W1 of the first pad portion 141a of the first circuit pattern layer 141 or the spacing W2 between the first pad portions 141a, a time required in a process of forming the cavity 160 increases, and thus processability may decrease. If the width W3 of the first portion S2-1 or the width W4 of the second portion S2-2 is greater than 90% of the width W1 of the first pad portion 141a of the first circuit pattern layer 141 or the spacing W2 between the first pad portions 141a, the upper surface of the second portion S2-2 may be located higher than the upper surface of the first pad portion 141a, as a result, the flatness of the chip may decrease when mounting the chip. If the width W3 of the first portion S2-1 or the width W4 of the second portion S2-2 is greater than 90% of the width W1 of the first pad portion 141a of the first circuit pattern layer 141 or the spacing W2 between the first pad portions 141a, it may be difficult to make a height of an upper end of the second portion S2-2 lower than a height of the upper surface of the first pad portion 141a. Additionally, this may cause a problem in which a mounting position of the chip is distorted as a portion of a lower surface of the chip contacts the second portion S2-2 during chip mounting.

At this time, in the embodiment, the first portion S2-1 and the second portion S2-2 may be formed regularly on the bottom surface S2 of the cavity 160 or the upper surface S2 of the first region R1 of the second insulating layer 120. For example, the first portion S2-1 and the second portion S2-2 may be formed regularly on the bottom surface S2 of the cavity 160 or the upper surface S2 of the first region R1 of the second insulating layer 120 in a width direction or a longitudinal direction

And, a thickness H2 of the first region R1 of the second insulating layer 120 may mean the average thickness of the height H2-1 of the first portion S2-1 and the thickness H2-2 of the second portion S2-2. Additionally, the thickness may also be expressed in terms of height.

Meanwhile, the first circuit pattern layer 141 of the embodiment includes a first pad portion 141a, a second pad portion 141b, and a trace 141C.

Specifically, the first pad portion 141a of the first circuit pattern layer 141 is disposed in the first region R1 of the upper surface of the first insulating layer 110. For example, the first pad portion 141a may vertically overlap the cavity 160.

Additionally, the second pad portion 141b of the first circuit pattern layer 141 is disposed in the second region R2 of the upper surface of the first insulating layer 110. For example, the second pad portion 141b may not vertically overlap the cavity 160.

Additionally, the first circuit pattern layer 141 of the embodiment includes the traces 141C. Additionally, the trace 141C may directly connect the first pad portion 141a and the second pad portion 141b.

Specifically, in the comparative example, the stop pattern 34 corresponding to the stop layer is disposed in an edge region of the cavity 160, and accordingly, it was impossible to form a trace directly connecting the first pad portion and the second pad portion.

In contrast, in the embodiment, the cavity 160 can be formed without a stop layer, and accordingly, it is possible to form a trace 141C that directly connects the first pad portion 141a and the second pad portion 141b.

The trace 141C may be divided into a plurality of portions.

For example, the trace 141C may include a first portion 141C1 adjacent to the first pad portion 141a and disposed in the first region R1 of the upper surface of the first insulating layer 110.

In addition, the trace 141C may include a second portion 141C2 adjacent to the second pad portion 141b, extending from the first portion 141C1 of the trace 141C and disposed in the second region R2 of the upper surface of the first insulating layer 110.

As described above, the embodiment allows the formation of a trace 141C directly connecting the first pad portion 141a and the second pad portion 141b, and accordingly, the signal transmission distance between the first pad portion 141a and the second pad portion 141b can be reduced compared to the comparative example. For example, in the comparative example, it was impossible to form the trace, and therefore, at least two through electrodes were included to connect the first pad portion and the second pad portion. In contrast, the embodiment allows direct connection between the first pad portion 141a and the second pad portion 141b without the through electrode, as a result, signal transmission loss can be minimized by reducing the signal transmission distance.

Meanwhile, as shown in FIG. 3B, a planar shape of the cavity 160 may include at least one convex portion 160a. That is, the cavity 160 is formed through a laser process. The laser process includes a process of irradiating a laser beam having a constant laser energy density to the second insulating layer 120 while being spaced apart at a certain spacing. Accordingly, the planar shape of an inner wall of the cavity 160 in the embodiment may include a plurality of convex portions 160a convex in an outward direction away from the cavity 160. Additionally, the planar shape of the inner wall of the cavity 160 may include a plurality of concave portions 160b located between the plurality of convex portions 160a and concave toward the inside of the cavity 160. In addition, shapes of the plurality of convex portions 160a and the plurality of concave portions 160b may correspond to the energy density. For example, the shape of the plurality of convex portions 160a may correspond to a laser beam size in a laser process. For example, a size of the convex portion 160a may correspond to the size of the laser beam in a laser process. The plurality of concave portions 160b may have a shape corresponding to a spacing between laser beams in the laser process. For example, a size of the concave portion 160b may correspond to a spacing between the laser beams.

Meanwhile, although it is shown in the drawing that the planar shape of the cavity 160 includes a convex portion 160a and a concave portion 160b, it is not limited thereto.

For example, the planar shape of the cavity 160 may include only the convex portion 160a as the spacing between laser beams in the laser process for forming the cavity 160 decreases.

Meanwhile, the first protective layer 151 includes an open portion 151a that vertically overlaps the cavity 160.

At this time, the first open portion 151a of the first embodiment may be formed through a process of exposing and developing the first protective layer 151.

At this time, the cavity 160 includes a region whose width changes in the thickness direction.

Additionally, the open portion 151a of the first protective layer 151 includes a region having the same width as the cavity 160.

For example, the width of at least one region of the open portion 151a of the first protective layer 151 may be the same as the width of at least one region of the cavity 160.

At this time, the open portion 151a of the first protective layer 151 of the first embodiment can be formed through a process of exposing and developing the first protective layer 151. Through this, an inner wall of the open portion 151a of the first protective layer 151 may have an inclination close to 90 degrees. However, the inner wall of the open portion 151a may have a certain inclination with respect to 90 degrees depending on the process conditions for exposing and developing the first protective layer 151.

For example, the open portion 151a of the first protective layer 151 may include a region whose width increases as it moves toward the second insulating layer 120. For example, the open portion 151a of the first protective layer 151 may include a region whose width decreases as it moves toward the second insulating layer 120. For example, the open portion 151a of the first protective layer 151 may include a region whose width does not change as it moves toward the second insulating layer 120.

Preferably, as shown in FIG. 4A, the open portion 151a of the first protective layer 151 may not change in width from an upper surface to a lower surface of the first protective layer 151. However, FIG. 4A shows an ideal shape of the open portion 151a, and the open portion 151a may include a region whose width substantially changes.

For example, the open portion 151a of the first protective layer 151 may include a first region 151S1 having an inclination A1 close to 90 degrees. At this time, the open portion 151a of the first protective layer 151 of the first embodiment may include only the first region 151S1. At this time, the drawing shows that the first region 151S1 has an inclination of 90 degrees whose width does not change, but this represents an ideal shape. Substantially, the first region 151S1 may include a portion whose width changes.

Preferably, an inclination of the first region 151S1 of the open portion 151a of the first protective layer 151 may range from 80 degrees to 100 degrees. For example, the inclination of the first region 151S1 of the open portion 151a may range from 82 degrees to 98 degrees. For example, the inclination of the first region 151S1 of the open portion 151a may range from 85 degrees to 95 degrees. The inclination of the first region 151S1 may represent an average value of the inclination of an inner wall of the open portion 151a with respect to an upper surface of the first insulating layer that vertically overlaps the cavity 160.

Accordingly, in the embodiment, a portion of the first region 151S1 of the open portion 151a of the first protective layer 151 may have a width equal to the width of the cavity 160.

For example, the first region 151S1 of the open portion 151a of the first protective layer 151 may include a portion equal to the width of the cavity 160. For example, the width of a region adjacent to the open portion 151a among all regions in the thickness direction of the cavity 160 may be equal to a width of at least a portion of the first region 151S1 of the open portion 151a.

Therefore, the embodiment can eliminate the dead region caused by the difference between the width of the open portion 151a of the first protective layer 151 and the width of the cavity 160, thereby reducing the overall size of the circuit board.

Meanwhile, a reason why the width of the open portion 151a of the first protective layer 151 in the embodiment may be the same as the width of the cavity 160 is as follows.

In the comparative example, after forming a cavity in the insulating layer, an open portion is formed in the protective layer.

Unlike this, in the embodiment, after forming the open portion 151a in the first protective layer 151, the cavity 160 is formed to vertically overlap the open portion. Accordingly, the width of the cavity 160 in the embodiment may be substantially the same as the width of the open portion 151a.

Specifically, a strength of the first protective layer 151 in the embodiment may be greater than a strength of the second insulating layer 120. For example, a content of fillers included in the first protective layer 151 may be greater than a content of fillers included in the second insulating layer 120.

Accordingly, a first energy density for processing the first protective layer 151 may be greater than a second energy density for processing the second insulating layer 120.

For example, when the laser of the second energy density is irradiated to the first protective layer 151 and the second insulating layer 120, the first protective layer 151 is not processed, and only the second insulating layer 120 can be processed.

Accordingly, in the embodiment, before forming the cavity 160 in the second insulating layer 120, the open portion 151a of the first protective layer 151 is formed on the second insulating layer 120..

In addition, the embodiment may proceed with a process of forming a cavity 160 having substantially the same width as the open portion 151a in the second insulating layer 120, using the first protective layer 151 including the open portion 151a as a mask.

That is, when a laser of a second energy density is irradiated on the first protective layer 151 after the open portion 151a is formed, the first protective layer 151 is not processed, and only one region of the second insulating layer 120 that vertically overlaps the open portion 151a of the first protective layer 151 can be processed. Through this, the embodiment uses the first protective layer 151 as a mask to form a cavity 160 that vertically overlaps the open portion 151a, and accordingly, the width of the open portion 151a and the width of the cavity 160 in a region closest to the open portion 151a can be made the same. Through this, the embodiment can eliminate the dead region formed due to the difference in width between the open portion 151a and the cavity 160.

Meanwhile, as shown in FIG. 4B, the open portion 151a of the first protective layer 151 may include a second region 151S2 having an inclination whose width increases toward the upper surface 151T of the first protective layer 151. At this time, an inner wall of the second region 151S2 may include a curved surface. For example, the open portion 151a of the first protective layer 151 may include a first region 151S1 and a second region 151S2 extending from the first region 151S1 and including a curved surface. Additionally, the second region 151S2 may be adjacent to the upper surface 151T of the first protective layer 151.

An inclination A2 of the second region 151S2 may satisfy a range between 120 degrees and 160 degrees. For example, the inclination A2 of the second region 151S2 may satisfy a range between 125 degrees and 155 degrees. For example, the inclination A2 of the second region 151S2 may satisfy a range between 130 degrees and 150 degrees. At this time, the inclination A2 of the second region 151S2 may mean an internal angle between a virtual straight line connecting one end and the other end of the second region 151S2 and a reference surface. For example, the reference surface may be a virtual straight line parallel to the upper or lower surface of the first insulating layer 110. For example, the reference surface may be a virtual straight line parallel to the upper or lower surface of the second insulating layer 120. For example, the reference surface may be a virtual straight line parallel to the upper or lower surface of the first protective layer 151.

At this time, the second region 151S2 may be formed during a laser process to form the cavity 160 after the open portion 151a is formed in the first protective layer 151.

That is, the laser process for forming the cavity 160 is performed using the first protective layer 151 as a mask.

At this time, when performing the laser process, a laser beam may be continuously irradiated to the upper portion of the inner wall of the open portion 151a of the first protective layer 151. Accordingly, the first protective layer 151 may include a second region 151S2 including the curved surface as described above. Here, the embodiment may adjust the process conditions of the laser process for forming the cavity 160 and prevent the second region 151S2 from being included in the inner wall of the open portion 151a of the first protective layer 151. However, in the embodiment, the second region 151S2 having a curved surface is included in the inner wall of the open portion 151a of the first protective layer 151.

In addition, the second region 151S2, which is the upper part of the inner wall of the open portion 151a of the first protective layer 151, may function to increase the width of the open portion 151a that vertically overlaps the cavity 160 under the condition of not forming the dead region. Additionally, a process of mounting a chip in the cavity 160 can be facilitated by including a second region 151S2 in the inner wall of the open portion 151a of the first protective layer 151. In addition, when applying a molding layer (described later) for molding the cavity 160, the embodiment may guide the molding layer to move into the cavity 160 along the curved surface of the second region 151S2, thereby providing ease of process. Furthermore, the second region 151S2 of the inner wall of the open portion 151a of the first protective layer 151 has a curved surface, and accordingly, the embodiment can increase a contact area with the molding layer, thereby improving adhesion with the molding layer.

Meanwhile, as shown in FIG. 4C, the open portion 151a of the first protective layer 151 may include a recess portion 151U. The recess portion 151U may be formed in a region adjacent to the second insulating layer 120 among the inner wall of the open portion 151a of the first protective layer 151. The recess portion 151U may mean an undercut formed on the inner wall of the open portion 151a of the first protective layer 151 toward the inside of the first protective layer 151. A horizontal distance UW of the recess portion 151U in the embodiment may satisfy a range of 0.1µm to 10µm. For example, the horizontal distance UW of the recess portion 151U of the embodiment may satisfy a range between 0.5 µm and 8 µm. For example, the horizontal distance UW of the recess portion 151U of the embodiment may satisfy a range between 0.7 µm and 6 µm.

If the horizontal distance UW of the recess portion 151U is greater than 10µm, the contact area between the first protective layer 151 and the second insulating layer 120 is reduced by an area corresponding to the horizontal distance UW of the recess portion 151U. Accordingly, a problem in which the first protective layer 151 is separated from the second insulating layer 120 may occur. Additionally, if the horizontal distance UW of the recess portion 151U is less than 0.1 µm, an effect of the function of the recess portion 151U described below may be insufficient..

At this time, as in the comparative example, the recess portion 151U may form a dead region in which at least a portion of the upper surface of the second insulating layer is not covered by the first protective layer. However, the first protective layer 151 of the embodiment includes a region that vertically overlaps the recess portion 151U. Through this, the embodiment prevents the recess portion 151U from functioning as a dead region, thereby reducing the size of the dead region compared to the comparative example.

Meanwhile, the recess portion 151U of the embodiment may be formed according to exposure conditions performed in the process of forming the open portion 151a in the first protective layer 151.

For example, in order to form the open portion 151a in the first protective layer 151, the embodiment may proceed with a process of exposing a region of the entire region of the first protective layer 151 that does not vertically overlap the open portion 151a. At this time, the embodiment may adjust the conditions of the exposure process. Accordingly, a portion of a region adjacent to the second insulating layer 120 among the regions in the thickness direction of the first protective layer 151 is not exposed, and accordingly, the recess portion 151U corresponding to the undercut is can be formed.

That is, the embodiment can control exposure and development conditions in the process of forming the open portion 151a in the first protective layer 151, and accordingly, the embodiment can eliminate the recess portion 151U formed in the open portion 151a of the first protective layer 151, and further adjust the horizontal distance UW of the recess portion 151U. In addition, in the embodiment, a recess portion 151U having a horizontal distance UW within a certain range may be formed in the open portion 151a of the first protective layer 151. Therefore, the embodiment can reduce a size of the dead region and improve adhesion with the molding layer.

For example, the recess portion 151U of the open portion 151a of the first protective layer 151 in the embodiment may be filled with the molding layer during a process of forming the molding layer. Through this, the embodiment can increase a bonding area between the second insulating layer 120, the first protective layer 151, and the molding layer, and thereby secure mutual adhesion.

Meanwhile, the open portion 151a of the first protective layer 151 is formed through an exposure and development process, and the cavity 160 in the second insulating layer 120 is formed through a laser process.

Unlike this, both the open portion of the first protective layer and the cavity of the second insulating layer in the second embodiment may be formed through a laser process. However, a laser process for forming the open portion and a laser process for forming the cavity are not performed at once, and may be performed separately into a plurality of processes. For example, in an embodiment, a first laser process is performed to form an open portion in the first protective layer, and then, a second laser process is performed to form a cavity in the second insulating layer after the first laser process is completed. Accordingly, the inclination of the inner wall of the open portion formed on the first protective layer of the embodiment may correspond to the process conditions in the first laser process, and the inclination of the inner wall of the cavity formed in the second insulating layer 120 may correspond to the process conditions in the second laser process.

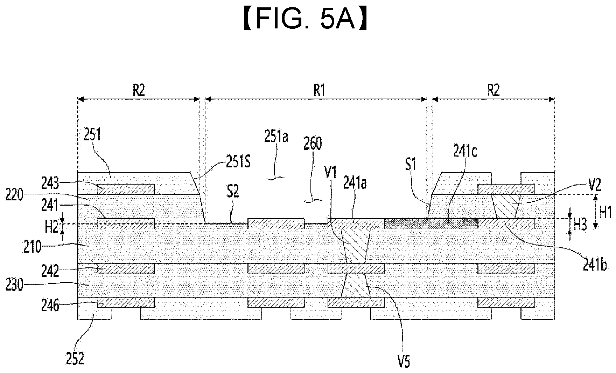

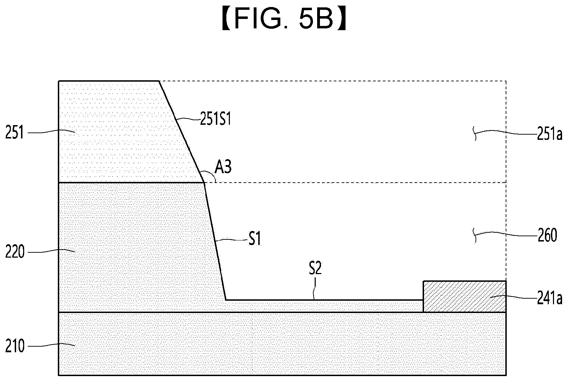

FIG. 5A is a view showing a circuit board according to a second embodiment, and FIG. 5B is an enlarged view of an open portion and cavity region of FIG. 5A.

Hereinafter, the circuit board according to the second embodiment will be described in detail with reference to FIGS. 5A to 5B.

At this time, the circuit board of the second embodiment of FIGS. 5A and 5B is substantially the same as the circuit board of the first embodiment of FIGS. 2A and 2B, except for the shape of the open portion formed in the first protective layer. Accordingly, the following description will be based on the open portion formed in the first protective layer of the second embodiment.

The circuit board of the second embodiment includes a first insulating layer 210, a second insulating layer 220, and a third insulating layer 230. At this time, the second insulating layer 220 and the third insulating layer 230 may be composed of a plurality of layers as shown in FIG. 2A.

Additionally, the circuit board of the second embodiment includes circuit pattern layers 241, 242, 243, and 246. Additionally, the circuit board of the second embodiment includes through electrodes V1, V2, and V5. Additionally, the circuit board of the second embodiment includes a first protective layer 251 and a second protective layer 252.

In addition, the second insulating layer 220 includes a cavity 260. Additionally, the first protective layer 251 includes an open portion 251a. At this time, the cavity 260 formed in the second insulating layer 220 has substantially the same structure and shape as the cavity 160 of the circuit board of the first embodiment, and therefore detailed description thereof will be omitted.

Meanwhile, the first protective layer 251 of the second embodiment includes an open portion 251a.

At this time, a planar shape of the open portion 251a of the first protective layer 251 includes a plurality of convex portions. For example, the planar shape of the open portion 251a of the first protective layer 251 may include a convex portion and a concave portion corresponding to the planar shape of the cavity described in FIG. 3B. That is, the open portion 251a of the first protective layer 251 in the second embodiment is formed through a first laser process, and accordingly, the planar shape of the open portion 251a of the first protective layer 251 may include a convex portion that is convex in an inner direction (or a direction away from the open portion) of the first protective layer 251 to correspond to the process conditions in the first laser process. Additionally, the planar shape of the open portion 251a of the first protective layer 251 may include a concave portion that is concave in an outer direction (or a direction toward the open portion) of the first protective layer 21. Additionally, the planar shape of the open portion of the first protective layer 251 may include only the convex portion.

At this time, a size (or diameter) of the convex portion of the cavity 260 may be different from a size of the convex portion of the open portion 251a. Preferably, the size (or diameter) of the convex portion of the cavity 260 may be larger than the size of the convex portion of the open portion 251a. This is because the laser beam size in the first laser process for forming the open portion 251a is larger than the laser beam size in the second laser process for forming the cavity. This will be explained below.

At this time, the open portion 251a has an inclination whose width gradually decreases as it approaches the second insulating layer 220. For example, the open portion 251a of the first protective layer 251 includes a first region having a second inclination different from the first inclination of the cavity while including a region with the same width as the cavity 260.

Additionally, the cavity 260 has a first inclination whose width gradually decreases as it moves away from the first protective layer 251. For example, the open portion 251a has a second inclination whose width gradually decreases as it approaches the cavity 260.

The first inclination of the cavity 260 may mean an inclination connecting one end of the inner wall of the cavity 260 adjacent to the upper surface of the second insulating layer 220, and the other end of the inner wall of the cavity 260 adjacent to the lower surface of the second insulating layer 220 or the bottom surface of the cavity 260.

Additionally, the second inclination of the open portion 251a may mean an inclination connecting one end of the inner wall of the open portion 251a adjacent to the upper surface of the first protective layer 251, and the other end of the inner wall of the open portion 251a adjacent to the lower surface of the first protective layer 251.

At this time, at least a portion of the region in the thickness direction of the open portion 251a may have a width equal to the width of at least a portion of the regions in the thickness direction of the cavity 260.

For example, the open portion 251a includes a region having the same width as the upper region of the cavity 260. For example, a lower region of the open portion 251a may have the same width as an upper region of the cavity 260.

At this time, the open portion 251a and the cavity 260 of the second embodiment are each formed through a laser process. For example, the open portion 251a is formed through a first laser process, and the cavity 260 is formed through a second laser process. Here, the process conditions of the first laser process and the process conditions of the second laser process are different from each other.

Specifically, an energy density of a laser in the first laser process is greater than an energy density of a laser in the second laser process.

For example, a laser power (or intensity) in the first laser process to form the open portion 251a may be greater than a laser power (or intensity) in the second laser process to form the cavity 260.

For example, the laser power in the first laser process may be greater than 0.18mJ. For example, the laser power in the first laser process may range from 0.18 mJ to 2.0 mJ. For example, the laser power in the first laser process may range from 0.18 mJ to 1.5 mJ. For example, the laser power in the first laser process may range from 0.18 mJ to 1.3 mJ. If the laser power in the first laser process is less than 0.18mJ, a process time for forming the open portion 251a in the first protective layer 251 may increase, or the open portion 251a may not be formed normally.

Meanwhile, the laser power in the second laser process may be less than 0.17mJ. For example, the laser power in the second laser process may range between 0.05mJ and 0.17mJ. For example, the laser power in the second laser process may range between 0.06mJ and 0.17mJ. For example, the laser power in the second laser process may range between 0.09mJ and 0.17mJ. If the laser power in the second laser process is less than 0.05 mJ, the process time required to form the cavity 260 may increase, or the cavity 260 may not be formed normally. If the laser power in the second laser process is greater than 0.17 mJ, the first protective layer 251 is also processed in the process of forming the cavity 260. Accordingly, there is a problem in that the size of the open portion 251a of the first protective layer 251 increases.

Accordingly, the second embodiment solves the problem that the size of the open portion 251a formed in the first protective layer 251 is expanded during the second laser process. Furthermore, the second embodiment can allow the cavity 260 to be easily formed by using the first protective layer 251 as a mask.

Meanwhile, as described above, an inclination of an inner wall S1 of the cavity 260 may range from 91 degrees to 130 degrees. For example, the inclination of the inner wall S1 of the cavity 260 may range from 93 degrees to 125 degrees. For example, the inclination of the inner wall S1 of the cavity 260 may range from 95 degrees to 120 degrees.

An inclination A3 of an inner wall 251S of the open portion 251a of the first protective layer 251 may be larger than the inclination A3 of the inner wall S1 of the cavity 260. This may be because the first laser process to form an open portion 251a in the first protective layer 251 is performed without a separate mask being placed and the first protective layer 251 functions as a mask in the process of forming the cavity 260.

The inclination A3 of the inner wall 251S of the open portion 251a of the first protective layer 251 may be larger than the inclination of the inner wall S1 of the cavity 260 and have a range between 95 degrees and 160 degrees. For example, the inclination A3 of the inner wall 251S of the open portion 251a of the first protective layer 251 may be larger than the inclination of the inner wall S1 of the cavity 260 and have a range between 98 degrees and 155 degrees. For example, the inclination A3 of the inner wall 251S of the open portion 251a of the first protective layer 251 may be larger than the inclination of the inner wall S1 of the cavity 260 and have a range between 100 degrees and 150 degrees.

Accordingly, the embodiment allows the inclination A3 of the inner wall 251S of the open portion 251a of the first protective layer 251 to be larger than the inclination A3 of the inner wall S1 of the cavity 260. Accordingly, the embodiment can ensure ease in the process of placing a chip in the cavity 260. Furthermore, the embodiment is possible to improve the flowability of the molding layer in the process of forming the molding layer by the feature of the inclination A3 of the inner wall 251S of the open portion 251a of the first protective layer 251, and furthermore, adhesion can be improved by increasing the contact area with the molding layer.

Meanwhile, it is preferable that the inner wall S1 of the cavity 260 has an inclination close to 90 degrees. At this time, as the laser beam size in the second laser process for forming the cavity 260 increases, the inclination of the inner wall S1 of the cavity 260 may increase.

In addition, unlike the inclination of the inner wall S1 of the cavity 260, if the inner wall 251S of the open portion 251a is close to 160 degrees, it may be advantageous to increase the adhesion with the molding layer.

Accordingly, a second laser beam size in the second laser process for forming the cavity 260 may be smaller than a first laser beam size in the first laser process for forming the open portion 251a.

For example, the first beam size in the first laser process may be 100µm to 300µm. And, the second beam size in the second laser process may be 30µm to 200µm. That is, the first beam size in the first laser process may have a size larger than the second beam size within a range described above. Additionally, the second beam size in the second laser process may be smaller than the first laser beam size within the range described above.

Accordingly, the size of the convex portion in the planar shape of the cavity 260 is smaller than the size of the convex portion in the planar shape of the open portion 251a.

### - semiconductor package -

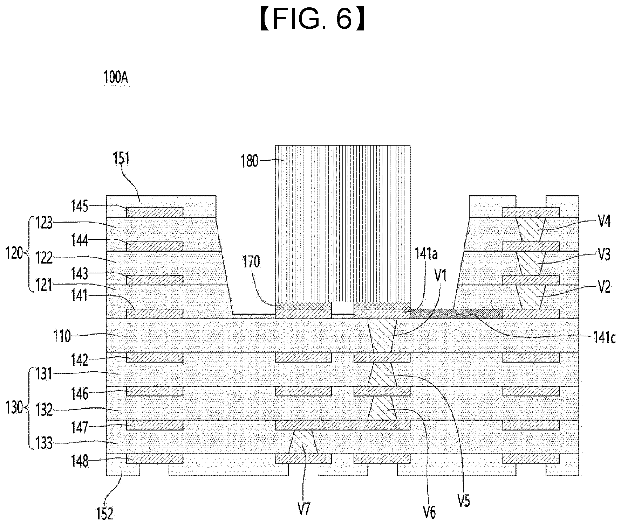

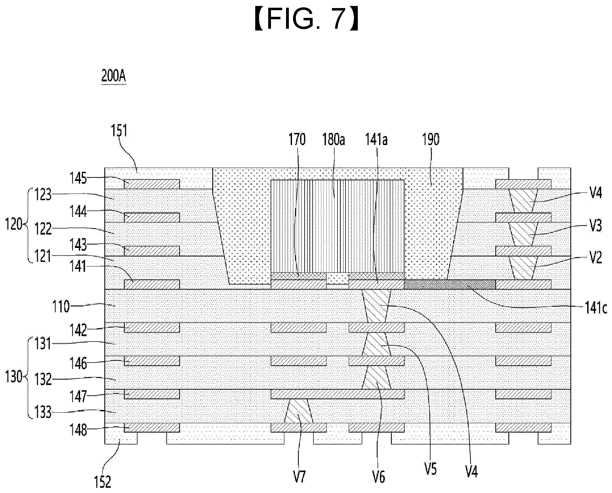

FIG. 6 is a view showing a semiconductor package according to a first embodiment, and FIG. 7 is a view showing a semiconductor package substrate according to a second embodiment.

At this time, the semiconductor package of the embodiment may use any one of the circuit boards shown in FIGS. 2A, 2B, and 5A as a package substrate. Hereinafter, a semiconductor package using the circuit board shown in FIG. 2A as a package substrate will be described. However, the embodiment is not limited thereto, and a semiconductor package may be provided by using the circuit board shown in FIGS. 2B and 5A as a package substrate.

A description of the circuit board included in the semiconductor package of the embodiment will be omitted.

The circuit board includes a cavity 160, and a first pad portion 141a may be disposed in the cavity 160. For example, the first pad portion 141a may vertically overlap the cavity 160.

Additionally, the first region R1 of the second insulating layer 120 is disposed between the first pad portions 141a and thereby supports the first pad portion 141a. At this time, the upper surface of the first pad portion 141a is located higher than the upper surface of the first region R2 of the second insulating layer 120. Accordingly, the chip 180 can be stably mounted on the first pad portion 141a without being affected by the first region of the second insulating layer. In other words, if the height of the first region of the second insulating layer 121 is higher than the height of the first pad portion 141a, the chip 180 may be mounted in an inclined state on the first pad portion 141a, and furthermore, a defect may occur in the electrical connection with the first pad portion 141a.

In this case, the chip 180 may be electronic components such as chips, which may be divided into active devices and passive devices. In addition, the active device is a device that actively uses a non-linear portion, and the passive device refers to a device that does not use the non-linear characteristic even though both linear and non-linear characteristics exist. In addition, the passive device may include a transistor, an IC semiconductor chip, and the like, and the passive device may include a capacitor, a resistor, an inductor, and the like. The passive device is mounted on a general circuit board to increase a signal processing speed of a semiconductor chip, which is an active device, or to perform a filtering function.

Meanwhile, a connection portion 170 may be disposed on the pad portion 141a. A planar shape of the connection portion 170 may be a quadrangle. The connection portion 170 is disposed on the first pad portion 141a and electrically connects the chip 180 and the first pad portion 141a while fixing the electronic device 180. To this end, the first pad portion 141a may be formed of a conductive material. For example, the connection portion 170 may be a solder ball. In the connection portion 170, a heterogeneous material may be contained in the solder. The solder may be composed of at least one of SnCu, SnPb, and SnAgCu. In addition, the heterogeneous material may include any one of Al, Sb, Bi, Cu, Ni, In, Pb, Ag, Sn, Zn, Ga, Cd, and Fe.

Meanwhile, an upper surface of the chip 180 may be positioned higher than the surface of the uppermost layer of the circuit board 100. However, the embodiment is not limited thereto, and depending on the type of the chip 180, the upper surface of the chip 180 may be disposed at the same height as the surface of the uppermost layer of the circuit board 100 or may be positioned lower otherwise.

Referring to FIG. 7, the semiconductor package 200A in the embodiment includes the circuit board and a chip 180a mounted in the cavity 160 of the circuit board.

In addition, the semiconductor package 200A further includes a molding layer disposed in the cavity 160 to cover the chip 180a.

The molding layer 190 may be selectively disposed in the cavity 160 to protect the electronic device 180a mounted in the cavity 160.

The molding layer 190 may be formed of a molding resin, for example, EMC (Epoxy Molding Compound). However, the embodiment is not limited thereto, and the molding layer 190 may be formed of various other molding resins in addition to EMC.

The circuit board 100 includes a cavity 160, and a first pad portion 141a may be exposed in the cavity 160. In this case, the second-first insulating layer 121 may be disposed in a region other than the area where the first pad portion 141a is formed within the cavity 160.

In the embodiment, the molding layer 190 is disposed in contact with the inner wall S1 and the bottom surface S2 of the cavity 160. At this time, the inner wall S1 and the bottom surface S2 of the cavity 160 have a certain surface roughness, and thus the bonding force with the molding layer 190 can be improved.

At this time, the molding layer 190 may be formed to fill the recess portion 151U formed in the open portion 151a of the first protective layer 151.

### - Method of manufacturing circuit board -

Hereinafter, a method of manufacturing a circuit board according to an embodiment will be described with reference to the accompanying drawings.

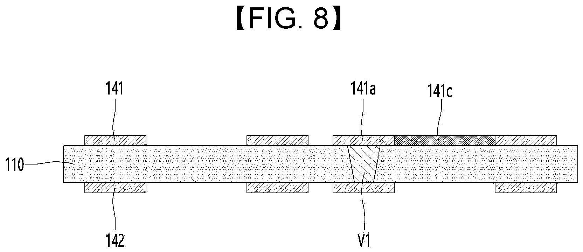

FIGS. 8 to 12 are views showing a method of manufacturing the circuit board shown in FIG. 2A in order of processes. However, the embodiment is not limited to this, and the circuit board shown in FIG. 2B or FIG. 5A may be manufactured based on the manufacturing method below.

Referring to FIG. 8, the first insulating layer 110 may be prepared, and first and second circuit pattern layers 141 and 142 may be formed on the surface of the first insulating layer 110, and the first through electrode V1 passing through the first insulating layer 110 and electrically connecting the first and second circuit pattern layers 141 and 142 may be formed.

The first insulating layer 110 may be prepreg, but is not limited thereto.

A metal layer (not shown) is laminated on the surface of the first insulating layer 110. The metal layer may be formed by electroless plating a metal including copper on the first insulating layer 110. In addition, unlike the formation of the metal layer by electroless plating on the first insulating layer 110, copper clad laminate (CCL) may be used.

When the metal layer is formed by electroless plating, roughness is provided to the upper surface of the first insulating layer 110 so that plating can be performed smoothly. Then, by patterning the metal layer, first and second circuit pattern layers 141 and 142 are respectively formed on the upper and lower surfaces of the first insulating layer 110. In this case, the first circuit pattern layer 141 may include a first pad portion 141a connected to the chips 180 and 180a to be mounted on the first insulating layer 110 later through the connection portion 170.

As described above, the first and second circuit pattern layers 141 and 142 may be formed by an additive process, a subtractive process, a modified semi additive process (MSAP) and a semi additive process (SAP) method, which is a typical circuit board manufacturing process, and a detailed description thereof will be omitted herein.

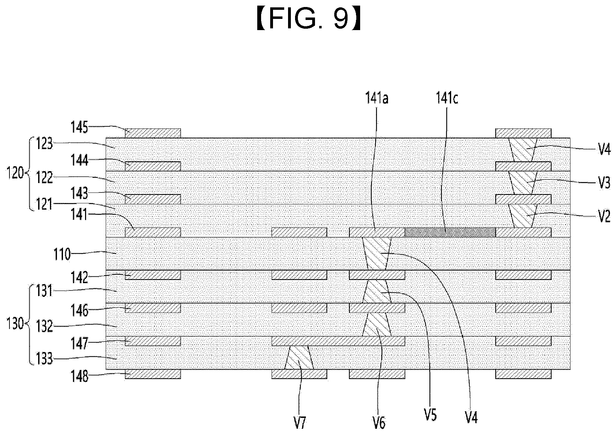

Next, referring to FIG. 9, a process of laminating the second insulating layer 120 and the third insulating layer 130 on upper and lower portions of the first insulating layer 110 may be performed, respectively.

In this case, the second insulating layer 120 has a structure of a plurality of layers. For example, the second insulating layer 120 may include the second-first insulating layer 121 disposed on the upper surface of the first insulating layer 110, the second-second insulating layer 122 disposed on the upper surface of the second-first insulating layer 121, and the second-third insulating layer 123 disposed on the upper surface of the second-second insulating layer 122.

In addition, the third insulating layer 130 has a plurality of layer structures. For example, the third insulating layer 130 may include the third-first insulating layer 131 disposed under a lower surface of the first insulating layer 110, the third-second insulating layer 132 disposed under a lower surface of the third-first insulating layer 131, and the third-third insulating layer 133 disposed under a lower surface of the third-second insulating layer 132.

However, the embodiment is not limited thereto, and as shown in FIG. 2B, the second insulating layer 120 and the third insulating layer 130 may be composed of a single layer.

In addition, the second insulating layer 120 and the third insulating layer 130 may be composed of RCC.

That is, all of the plurality of layers constituting the second insulating layer 120 and the third insulating layer 130 in the first embodiment may be composed of RCC.

In addition, a process of forming a circuit pattern on the surface of the second insulating layer 120 may be performed. For example, a process of forming a plurality of third circuit pattern layers 143 spaced apart from each other by a predetermined distance on the upper surface of the second-first insulating layer 121 may be performed. In addition, a process of forming a plurality of fourth circuit pattern layers 144 spaced apart from each other by a predetermined distance may be performed on the upper surface of the second-second insulating layer 122. In addition, a process of forming a plurality of fifth circuit pattern layers 145 spaced apart from each other by a predetermined distance on the upper surface of the second-third insulating layer 123 may be performed.

In addition, a process of forming a circuit pattern on the surface of the third insulating layer 130 may be performed. For example, a process of forming a plurality of sixth circuit pattern layers 146 spaced apart from each other by a predetermined distance on the lower surface of the third-first insulating layer 131 may be performed. In addition, a process of forming a plurality of seventh circuit pattern layers 147 spaced apart from each other by a predetermined distance on the lower surface of the third-second insulating layer 132 may be performed. In addition, a process of forming a plurality of eighth circuit pattern layers 148 spaced apart from each other by a predetermined distance on the lower surface of the third-third insulating layer 133 may be performed.

In addition, a process of forming through electrodes V1, V2, V3, V4, V5, V6, and V7 which electrically connect circuit patterns disposed on different layers in the first insulating layer 110, the second insulating layer 120, and the third insulating layer 130 to each other may be performed.

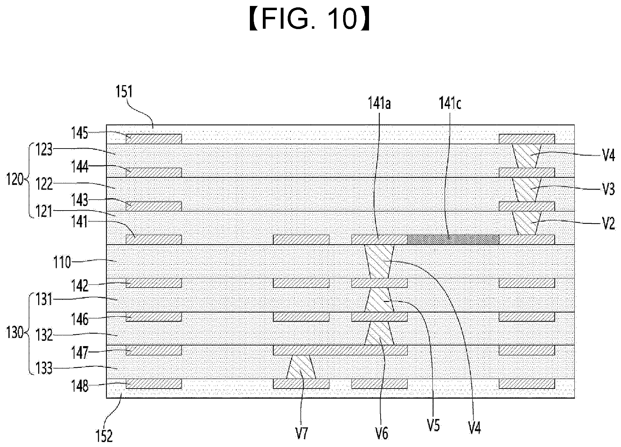

Next, referring to FIG. 10, the embodiment may proceed with a process of forming a first protective layer 151 on the second insulating layer 120, and a process of forming a second protective layer 152 below the third insulating layer 130.

At this time, no open portions are formed in the first protective layer 151 and the second protective layer 152.

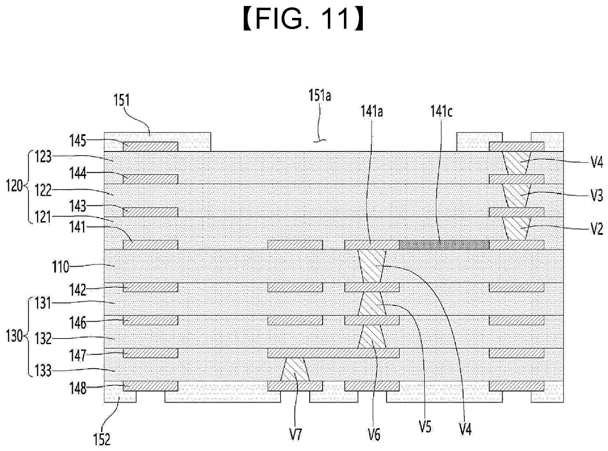

Next, referring to FIG. 11, the embodiment may proceed with a process of forming an open portion in the first protective layer 151 and the second protective layer 152. That is, the first protective layer 151 and the second protective layer 152 of the embodiment further include an open portion that vertically overlaps the circuit pattern layer in addition to the open portion 151a described above.

At this time, the first embodiment exposes and cures the entire region of the first protective layer 151 excluding the region where the open portion 151a will be formed. The embodiment proceeds with a process of developing and removing the unexposed and uncured regions. Accordingly, the embodiment may form the open portion 151a. Accordingly, the open portion 151a formed on the first protective layer 151 may have one of the shapes shown in FIGS. 4A to 4C.

However, the embodiment is not limited thereto, and the open portion in the first protective layer can be formed by performing a first laser process. And, when the open portion in the first protective layer is formed through a first laser process, and the open portion may have the shape shown in FIGS. 5A and 5B.

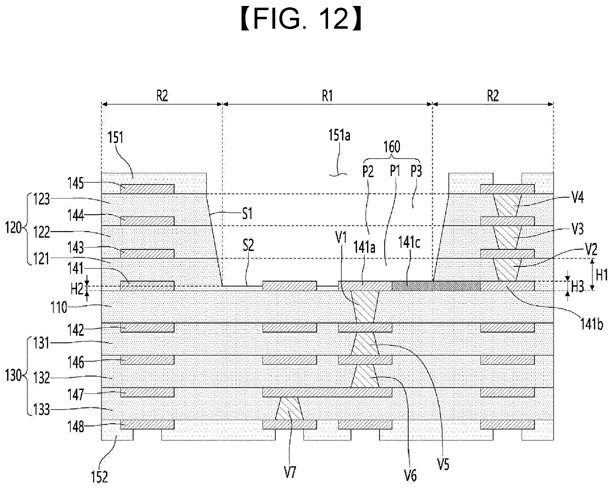

Next, the embodiment is as shown in FIG. 12, in the embodiment, a laser process is performed using the first protective layer 151 as a mask. Accordingly, the embodiment may form a cavity 160 that vertically overlaps the open portion 151a of the first protective layer 151.

The characteristics, structures, effects, and the like described in the above-described embodiments are included in at least one embodiment, but are not limited to only one embodiment. Furthermore, the characteristic, structure, and effect illustrated in each embodiment may be combined or modified for other embodiments by a person skilled in the art. Therefore, it should be construed that contents related to such combination and modification are included in the scope of the embodiment.

Embodiments are mostly described above, but the embodiments are merely examples and do not limit the embodiments, and a person skilled in the art may appreciate that several variations and applications not presented above may be made without departing from the essential characteristic of embodiments. For example, each component specifically represented in the embodiments may be varied. In addition, it should be construed that differences related to such a variation and such an application are included in the scope of the embodiment defined in the following claims.

## Claims

1. A circuit board comprising:
a first insulating layer;
a second insulating layer disposed on the first insulating layer and including a cavity; and
a first protective layer disposed on the second insulating layer and including an open portion vertically overlapping the cavity,
wherein the cavity has a first inclination whose width decreases toward the first insulating layer,
wherein the open portion includes a first region whose width changes with a second inclination different from the first inclination, and
wherein at least a portion of the first region of the open portion is equal to a width of a region adjacent to the first protective layer among an entire region of the cavity.

2. The circuit board of claim 1, wherein the second inclination of the first region with respect to an upper surface of the first insulating layer vertically overlapping the cavity has a range between 80 degrees and 100 degrees.

3. The circuit board of claim 2, wherein the first inclination of the cavity with respect to the upper surface of the first insulating layer vertically overlapping the cavity has a range between 91 degrees and 130 degrees.

4. The circuit board of any one of claims 1 to 3, wherein the open portion includes a second region adjacent to an upper surface of the first protective layer and having a third inclination different from the first and second inclinations.

5. The circuit board of claim 4, wherein at least a portion of an inner wall of the second region of the open portion includes a curved surface.

6. The circuit board of any one of claims 1 to 3, wherein the first region of the open portion includes a recess portion adjacent to an upper surface of the second insulating layer and recessed toward an inside of the first protective layer.

7. The circuit board of claim 1, wherein the second inclination is an inclination between one end of an inner wall of the open portion adjacent to an upper surface of the first protective layer and other end of the inner wall of the open portion adjacent to a lower surface of the first protective layer, and
wherein the first inclination with respect to the upper surface of the first insulating layer vertically overlapping the cavity is smaller than the second inclination with respect to an upper surface of the first insulating layer vertically overlapping the cavity.

8. The circuit board of claim 7, wherein the second inclination is greater than the first inclination and has a range from 95 degrees to 160 degrees.

9. The circuit board of claim 7, wherein the open portion has a planar shape including a plurality of convex portions that are convex toward an inside of the first protective layer.

10. The circuit board of claim 9, wherein the cavity includes a plurality of second convex portions convex toward an inside of the second insulating layer, and
wherein a size of the first convex portion is different from a size of the second convex portion.
